(19) Europäisches Patentamt
European Patent Office
Office européen des brevets

(11) EP 0 994 358 B1

(12) **EUROPÄISCHE PATENTSCHRIFT**

(45) Veröffentlichungstag und Bekanntmachung des Hinweises auf die Patenterteilung:
**11.02.2004 Patentblatt 2004/07**

(51) Int Cl.$^7$: **G01R 27/28**

(21) Anmeldenummer: **99119729.4**

(22) Anmeldetag: **05.10.1999**

(54) **Verfahren zur Bestimmung der Impulsantwort eines breitbandigen linearen Systems und Messanordnung zur Durchführung des Verfahrens**

Procedure for determining the impulse response of a broadband linear system and measuring system for the same

Système de mesure et procédure pour déterminer la réponse impulsionnelle d'un système linéaire à large bande

(84) Benannte Vertragsstaaten:
**FR GB IT SE**

(30) Priorität: **12.10.1998 DE 19846870**

(43) Veröffentlichungstag der Anmeldung:
**19.04.2000 Patentblatt 2000/16**

(73) Patentinhaber:
- **Peyerl, Peter, Dr.
98693 Ilmenau (DE)**
- **Sachs, Jürgen, Dr.
98711 Schmiedefeld (DE)**

(72) Erfinder:
- **Peyerl, Peter, Dr.
98693 Ilmenau (DE)**
- **Sachs, Jürgen, Dr.
98711 Schmiedefeld (DE)**

(74) Vertreter: **Engel, Christoph Klaus et al
Engel & Weihrauch,
Patent- und Rechtsanwälte,
Marktplatz 6
98527 Suhl/Thüringen (DE)**

(56) Entgegenhaltungen:
**WO-A-97/37437** **DE-A- 4 209 761**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 994 358 B1

Printed by Jouve, 75001 PARIS (FR)

## Beschreibung

Die Erfindung betrifft ein Verfahren zur Bestimmung der Impulsantwort eines breitbandigen linearen Systems. Insbesondere bezieht sich die Erfindung auf ein Verfahren, mit welchem die Impulsantwort eines derartigen Systems im Hochfrequenzbereich (hier etwa 100 MHz bis 10 GHz) bestimmt werden kann. Speziell betrifft die Erfindung auch ein Verfahren zur Bestimmung der Impulsantwort vielkanaliger breitbandiger linearer Systeme. Die Erfindung betrifft weiterhin ein Gerät zur Durchführung derartiger Verfahren.

Im Bereich der Elektrotechnik und Elektronik werden die Übertragungseigenschaften linearer Systeme beispielsweise durch Bestimmung der Impulsantwort ***g*(*t*)** bzw. der Übertragungsfunktion $\underline{\boldsymbol{G}}(\boldsymbol{f})$ ermittelt und gekennzeichnet. Unter einem linearen System wird nachfolgend jedes System verstanden, bei welchem die Ausgangsgrößen ***y*(*t*)** in einem durch die nachfolgend angegebenen Gleichungen definierten Verhältnis zu den Eingangsgrößen ***x*(*t*)** stehen:

$$y(t)=\int g(\tau)x(t-\tau)d\tau \qquad (1)$$

$$\underline{Y}(f)=\underline{G}(f)\underline{X}(f) \qquad (2)$$

Bei Systemen mit einem Eingang ***x*** und einem Ausgang ***y*** ergeben sich skalare Gleichungen, während Systeme mit mehrfachen Eingängen und mehrfachen Ausgängen durch Matrix-Beziehungen beschrieben werden. Die Impulsantwort ***g*(*t*)** bzw. die Übertragungsfunktion $\underline{\boldsymbol{G}}(\boldsymbol{f})$ widerspiegeln die Eigenschaften des betrachteten Systems.

Bei der Entwicklung, Fertigung und Untersuchung von beliebigen technischen Systemen, insbesondere von UWB-Sensoren (ultra wideband = UWB) und Sensorarrays, ist die meßtechnische Bestimmung der Impulsantwort bzw. der Übertragungsfunktion eine wesentliche Frage.

Im Stand der Technik sind zur meßtechnischen Ermittlung der Impulsantwort bzw. der Übertragungsfunktion drei grundsätzliche Prinzipien gebräuchlich. Bei der sogenannten Impulsmeßtechnik werden alle Eingänge des zu untersuchenden Systems jeweils mit einem schmalen Impuls angesteuert und die Ausgangssignale an allen Ausgängen des Systems gemessen. Im Idealfall wird ein Dirac-Stoß als Eingangsimpuls verwendet. Unter Auflösung der oben genannten Integralgleichung (1) kann die Impulsantwort des Systems bestimmt werden. Die besonderen Schwierigkeiten dieses Verfahrens bestehen darin, daß ein möglichst steiler Eingangsimpuls mit einer hohen Spannung an die Eingänge angelegt werden muß, um potentiell vorhandene Störungen weitgehend auszuschließen. Meßsysteme, die in dem hier interessierenden Hoch- und Höchstfrequenzbereich unter Ausnutzung des Impulsmeßverfahrens arbeiten, stellen nur eine geringe Meßgeschwindigkeit zur Verfügung und erfordern einen hohen apparativen Aufwand.

Ein zweites in der Praxis eingesetztes Verfahren ist die sogenannte Sinusmeßtechnik, bei der dem zu untersuchenden System Testsignale zugeführt werden, die aus einer Vielzahl von Sinusschwingungen verschiedener Frequenzen bestehen. Aufgrund der nötigen hohen Anzahl verschiedener Frequenzen in den Testsignalen ist dieses Verfahren sehr langsam und erfordert einen sehr hohen apparativen Aufwand.

Als drittes Prinzip ist das Korrelationsmeßverfahren bekannt. Im Gegensatz zur Impuls- und Sinusmeßtechnik können hierbei beliebige Signalformen als Testsignal eingesetzt werden, wenn ihre Bandbreite ausreichend groß ist. Im Unterschied zur Sinusmeßtechnik erfolgen alle Auswertungen und Betrachtungen nicht im Frequenzbereich sondern im jeweiligen Zeitbereich. Zwischen den Korrelationsfunktionen gilt dann für Systeme mit ***K*** Eingängen und ***L*** Ausgängen folgender Zusammenhang:

$$\psi_{xy}(\tau) = \int g(\xi)\psi_{xx}(\xi-\tau)d\xi \qquad (3)$$

mit

$$\psi_{xy}(\tau) = \int y(t)x^{T}(t+\tau)dt \qquad [L,K]\text{ - Matrix}$$

$$\psi_{xx}(\tau) = \int x(t)x^{T}(t+\tau)dt \approx \delta(\tau)D \qquad [K,K]\text{ - Matrix}$$

$\mathbf{x}^{T}$ ist die Transponierte von $\mathbf{x}$.

$$x(t)=[x_1(t),x_2(t),...,x_K(t)]^T \text{ - Vektor der Eingangssignale}$$

$$y(t)=[y_1(t),y_2(t),...,y_L(t)]^T \text{ - Vektor der Ausgangssignale}$$

**D** - Diagonalmatrix

Als Testsignale sind solche Signale zu wählen, deren Autokorrelationsmatrix einer Diagonalmatrix aus Dirac-Funktionen möglichst nahe kommt.

Die an UWB-Korrelationsverfahren gestellten Anforderungen werden von bisherigen Systemen nur teilweise und mit unverhältnismäßigem Aufwand erfüllt. Außerdem ist es wünschenswert, daß die am System angelegte Bandbreite auf einfache Weise geändert werden kann, um mit ein und demselben Meßgerät unterschiedliche Systeme bzw. unterschiedliche Eigenschaften derselben Systeme in verschiedenen Frequenzbereichen beurteilen zu können. Da diese Anforderungen mit bekannten Korrelationsmeßverfahren nicht erfüllt werden können, wurden Korrelationsmeßverfahren bislang nur in sehr beschränktem Umfang bei der Vermessung hochfrequenter Systeme eingesetzt.

Aus dem Artikel "Anwendungen der Maximalfolgenmeßtechnik in der Akustik" von M. Vorländer, erschienen in den Tagungsunterlagen "Fortschritte der Akustik - DAGA 94" Bad Honnef: DPG GmbH 1994, ist ein Korrelationsmeßverfahren bekannt, bei welchem als Eingangssignale für das zu untersuchende System sogenannte Maximalfolgen verwendet und die Ausgangssignale zur Bildung der Impulsantwort einer Hadamard-Transformation unterzogen werden. Aus diesem Artikel ist u.a. auch das Faltungsintegral der Korrelationsmeßtechnik in seiner allgemeinen Form bekannt:

$$\Phi_{ss'}(\tau) = \int_{-\infty}^{\infty} h(t')\,\Phi_{ss}(\tau - t')\,dt' \quad \approx \quad h(\tau)$$

Ein Vorteil der Korrelationsmeßverfahren besteht demnach darin, daß nicht das Anregungssignal selbst einem Dirac-Stoß möglichst ähnlich sein muß, sondern dessen Autokorrelationsfunktion. Vor allem hinsichtlich der Aussteuerung des Systems und des Signal/Rausch-Verhältnisses ist dies nützlich. Periodische binäre pseudostochastische Rauschsignale mit einer Autokorrelationsfunktion, die einem Dirac-Stoß sehr nahe kommt, werden als Maximalfolgen bezeichnet.

Der vorgenannte Artikel zeigt die Anwendung eines Korrelationsmeßverfahrens, insbesondere die Maximalfolgenmeßtechnik im Gebiet der Akustik. Mit dem bekannten Verfahren und den entsprechenden Geräten können jedoch keine Messungen im Hochfrequenzbereich durchgeführt werden.

In der Dissertationsschrift von H. Alrutz mit dem Titel "Über die Anwendung von Pseudorauschfolgen zur Messung an linearen Übertragungssystemen", Göttingen 1983, wird u.a. auch die Möglichkeit der Verwendung von Maximalfolgen als Testsignale bei Messungen im Hochfrequenzbereich diskutiert. Dabei wird ein Maximalfolgengenerator vorgeschlagen, der zwei Schieberegister und einen schnellen Komparator verwendet. Mit diesem Aufbau kann die Maximalfolge mit dem Abtasttakt synchronisiert werden, wobei immer nur eine Abtastung pro Periode der Maximalfolge möglich ist. Mehrfachabtastungen innerhalb einer Periode, die Voraussetzung zur Geschwindigkeitserhöhung sind, können nicht durchgeführt werden. Ebenso ist eine Kaskadierung mehrerer Meßeinheiten schwierig.

In der DE 42 09 761 A1 ist ein Verfahren zum Ermitteln der Übertragungseigenschaften eines elektrischen Systems beschrieben. Dabei wird dem zu untersuchende System ein Testsignal eingespeist, dessen Autokorrelationsfunktion ein Deltaimpuls ist. Am Ausgang wird das Empfangssignal ausgewertet, indem mit einem Referenzsignal kreuzkorreliert wird. Das gewonnene Ausgangssignal gibt dann die Übertragungseigenschaften des Systems wieder. Dieses Verfahren wird vor allem für die Untersuchung von Leitungseigenschaften eingesetzt und eignet sich nicht zur schnellen Vermessung vielkanaliger Systeme.

Eine Aufgabe der vorliegenden Erfindung besteht somit darin, bestehende Vorbehalte zu überwinden und ein Verfahren zur Bestimmung der Impulsantwort eines breitbandigen linearen Systems bereitzustellen, welches die Nachteile des Standes der Technik vermeidet. Dabei soll eine hohe Meßrate und eine weitgehend digitale Meßwertverarbeitung ermöglicht werden, um ausreichend empfindliche Meßgeräte mit hoher Präzision verfügbar zu machen. Weiterhin wird angestrebt, aufgrund des Meßverfahrens eine integrierbare schaltungstechnische Lösung bereitzustellen, die dem Aufbau preiswerter, vielkanaliger und robuster Meßsysteme dient.

Diese Aufgabe wir durch das im Patentanspruch 1 angegebene Verfahren gelöst.

Das erfindungsgemäße Verfahren bietet den Vorteil, daß als Eingangssignal für das zu untersuchende System eine hochfrequente Maximalfolge verwendet werden kann. Dies gestattet den Einsatz einer als Hadamard-Transformation bekannten Rechenregel, wodurch die Korrelation zwischen Eingangs- und Ausgangssignal einfach realisierbar ist, so daß als Ergebnis dieser Korrelationsbestimmung die Impulsantwort des Systems zur Verfügung steht. Mit einem einfachen integrierbaren Aufbau kann durch die Anwendung des erfindungsgemäßen Verfahrens die Impulsantwort hochfrequenter Systeme mit hoher Genauigkeit bestimmt werden. Eine weiterer Vorteil des erfindungsgemäßen Verfahrens, der sich aus dem Einsatz einer Maximalfolge als Testsignal ergibt, besteht in der Energiestreuung über eine gesamte Periode der Maximalfolge, gegenüber einem ansonsten erforderlichen sehr leistungsstarken Impuls als Testsignal. Dies ermöglicht den Einsatz einfacher und preiswerter Baugruppen, wie beispielsweise Ausgangsverstärker und Empfänger.

Eine vorteilhafte Ausführungsform des erfindungsgemäßen Verfahrens zeichnet sich dadurch aus, daß die Frequenz des hochfrequenten Taktes $f_C$ einstellbar ist. Durch Veränderung der Taktfrequenz kann die Bandbreite des Testsignals auf einfache Weise den gewünschten Anforderungen angepaßt werden. Die Veränderung der Taktfrequenz bewirkt unmittelbar eine umgekehrt proportionale Veränderung der Impulsbreite der Maximalfolge und damit eine Änderung der Bandbreite des dem zu untersuchenden System eingespeisten Testsignals.

Dabei kann es auch vorteilhaft sein, den Takt gezielt während einer Messung zu verändern. Der Abtasttakt des Empfängerzweiges ist unmittelbar an den hochfrequenten Takt über ein vorgegebenes Teilungsverhältnis gekoppelt, so daß eine Veränderung des hochfrequenten Taktes auch eine Veränderung des Abtasttaktes zur Folge hat, wodurch die empfangenen Signale ohne weiteres als Meßsignale ausgewertet werden können. Andererseits hat die Taktveränderung ein "Verwischen" des Erregerspektrums und damit eine undeutliche Spektralanwort zur Folge. Zusätzlich kann die Ordnung m der Maximalfolge willkürlich verändert werden. Derartige Meßsysteme sind von außen nur schwer ortbar, so daß diese Ausführungsformen beispielsweise interessant sind, wenn Radarmessungen in nichtkooperativer Umgebung durchgeführt werden sollen oder mehrere gleichartige Systeme sich gegenseitig nicht stören sollen.

Bei einer bevorzugten Ausgestaltung der Erfindung ist das Teilungsverhältnis zur Erzeugung des Abtasttaktes einstellbar. Auf diese Weise kann der Abtasttakt an die Geschwindigkeit eines zur Umwandlung der analogen Abtastwerte in digitale Abtastwerte eingesetzten Analog-Digital-Wandlers angepaßt werden. Das Verfahren läßt sich somit unter unterschiedlichen apparativen Bedingungen anwenden, wobei je nach Verfügbarkeit und Kostenrahmen der für die spezielle Anwendung geeignete Analog-Digital-Wandler ausgewählt werden kann.

Bei einer vorteilhaften Ausführungsform werden Abtastwerte zwischengespeichert und bei der Abtastung nachfolgender Meßsignalwerte als Referenzwert verwendet, wobei die Abtastzeitpunkte auf verschiedene Perioden verteilt sind, jedoch projiziert auf eine Periode betrachtet, nicht mehr als eine Periodenlänge $t_C$ des hochfrequenten Taktes voneinander beabstandet sind. Auf diese Weise können Rückführsamplingverfahren eingesetzt werden, wodurch die Meßgenauigkeit und Bandbreite gesteigert werden kann.

Eine abgewandelte Ausführungsform des Verfahrens ist dadurch gekennzeichnet, daß die Maximalfolge $m(t)$ einem hochfrequenten Trägersignal $c(t)$ aufgeprägt wird, um eine modifizierte Maximalfolge $n(t)$ zur Verfügung zu stellen. Es ist besonders zweckmäßig, wenn als Trägersignal das hochfrequente Taktsignal $f_C$ verwendet wird. Dies bietet den Vorteil, daß das Frequenzspektrum der Maximalfolge zu höheren Frequenzen verschoben wird, um damit besonders breitbandige Bandpaßsysteme zu untersuchen.

Eine wiederum abgewandelte Ausführungsform des erfindungsgemäßen Verfahrens ist für die Bestimmung der Impulsantworten eines breitbandigen linearen Systems vorgesehen, welches mehrere Eingänge und/oder mehrere Ausgänge besitzt. Bei dieser Ausführungsform werden gleichzeitig oder nacheinander an jedem Eingang des Systems eine Maximalfolge als Testsignal angelegt, während an jedem Ausgang des Systems ein Meßsignal abgegriffen wird. Zur Bestimmung der Impulsantworten werden mindestens eine Anzahl von Messungen ausgeführt, die der Anzahl der Eingänge des Systems entspricht, wobei bei jeder Messung eine andere Kombination der Testsignale verwendet wird. Die Impulsantworten werden dann mit dem erfindungsgemäßen Verfahren bestimmt. Dabei ist es besonders zweckmäßig, wenn die Testsignale nach einem Kombinationsschema angelegt werden, welches einer Hadamardmatrix entspricht. Dies ermöglicht die einfache Berechnung der Impulsantworten und gewährleistet gleichzeitig einen großen Störabstand bei der Messung.

Durch die Erfindung wird auch eine Meßanordnung bereitgestellt, welche das vorgeschlagene Verfahren realisiert. Die Merkmale der erfindungsgemäßen Meßanordnung sind im Patentanspruch 8 wiedergegeben.

Eine bevorzugte Ausführungsform dieser Meßanordnung zeichnet sich dadurch aus, daß ein Signalumschalter vorgesehen ist, der die vom Maximalfolgengenerator gelieferte Maximalfolge an einen nicht-negierenden oder an einen negierenden Eingang des Ausgangsverstärkers liefert oder die Kopplung zwischen Maximalfolgengenerator und Ausgangsverstärker trennt. Dies ist besonders nützlich, wenn in der Meßanordnung mehrere Hochfrequenzbaugruppen betrieben werden, die Signale an mehrere Eingänge eines linearen Systems liefern bzw. von mehreren Ausgängen Meßsignale empfangen. In den ermittelten Meßsignalen kann aufgrund der unterschiedlichen Polarität der eingespeisten Maximalfolgen auf das dem Meßsignal zuzuordnende Eingangssignal rückgeschlossen werden.

Bei anderen Ausführungsformen kann die Abkopplung der Maximalfolge vom Ausgangsverstärker auch durch die Nutzung eines Schalteingangs (enable) am Maximalfolgengenerator realisiert werden.

Eine abgewandelte Ausführungsform der Meßanordnung zeichnet sich dadurch aus, das weiterhin ein Digital-Analog-Wandler vorgesehen ist, der die in einem vorangegangenen Abtastzyklus ermittelten Abtastwerte in ein analoges Rückführsignal umwandelt, welches der Abtastschaltung an einem Rückführeingang zugeführt wird. Eine derartige Schaltung ermöglicht den Einsatz eines sogenannten Rückführsamplers (Abtastschaltung mit Rückführung), wobei in nachfolgenden Abtastzyklen jeweils nur die Differenz zwischen dem vorangegangenen Abtastwert und dem neuen Abtastwert ermittelt werden muß. Auf diese Weise läßt sich der Abtastvorgang wesentlich beschleunigen. Durch geeignete Zwischenspeicherung der Abtastwerte kann als Rückführsignal der Abtastwert der unmittelbar vorangegangenen Periode des Meßsignals zur weiteren Abtastung herangezogen werden. Alternativ oder kombiniert mit dem soeben beschriebenen Prinzip kann das Meßsignal über eine Vielzahl von Perioden ausgewertet werden, wobei der zum gleichen Abtastzeitpunkt in einer oder mehreren vorangegangenen Perioden gewonnene Abtastwert als Rückführsignal dient, so daß eine Durchschnittsbildung (Mittelung) über eine Vielzahl von Perioden erfolgen kann.

Eine abgewandelte Ausführungsform der Meßanordnung zeichnet sich dadurch aus, daß der Maximalfolgengenerator einen Freigabeeingang besitzt, der ein Start/Stop-Signal zum Starten der Maximalfolge empfängt. Insbesondere ist es nützlich, wenn das Start/Stop-Signal über eine Synchronisationsschaltung zugeführt wird, welche den Zuführzeitpunkt zum Freigabeeingang mit Hilfe des Abtasttaktes steuert. Dies bietet den besonderen Vorteil, daß die Maximalfolge zu exakt definierten Zeitpunkten gestartet werden kann und gleichzeitig einfache digitale Schaltungselemente und Leitungen einsetzbar sind. Auch der Schaltungsaufwand zum synchronen Starten mehrerer Hochfrequenzbaugruppen wird damit sehr gering gehalten.

Es ist besonders zweckmäßig, wenn die Stromversorgungseinheit der Meßanordnung ein Schaltnetzteil ist, welches mit dem Abtasttakt getaktet wird. Die über die Stromversorgungseinheit zwangsläufig eingekoppelten Störungen können dann in bekannter Weise aus dem eigentlichen Meßsignal herausgefiltert werden.

Weiter Vorteile, Einzelheiten und Weiterbildungen der vorliegenden Erfindung ergeben sich aus der nachfolgenden Beschreibung bevorzugter Ausführungsformen, unter Bezugnahme auf die Zeichnungen. Es zeigen:

Fig. 1 ein Blockschaltbild einer Meßanordnung zur Bestimmung der Impulsantwort eines breitbandigen linearen Systems;

Fig. 2 ein Blockschaltbild eines beispielhaften Maximalfolgengenerators;

Fig. 3 Diagramme des zeitlichen Verlaufs und des Frequenzspektrums von Maximalfolgen;

Fig. 4 Diagramme eines periodischen Meßsignals und eines aus Abtastwerten gebildeten äquivalenten Signals;

Fig. 5 ein Blockschaltbild eines erweiterten Maximalfolgengenerators zur Verschiebung des Spektrums einer Maximalfolge;

Fig. 6 ein Diagramm der Hüllkurve des Spektrums einer modifizierten Maximalfolge;

Fig. 7 eine Darstellung des zeitlichen Signalverlaufs bei Verwendung der modifizierten Maximalfolge;

Fig. 8 eine sich ergebende Matrizengleichung zur Durchführung der Korrelation und zwei Matrizengleichungen, die sich durch Umsortierung ergeben;

Fig. 9 ein Blockschaltbild eines Datenverarbeitungsabschnitts zur Meßdatenverarbeitung unter Verwendung der modifizierten Maximalfolge;

Fig. 10 ein Blockschaltbild des möglichen Aufbaus einer integrierten Hochfrequenzbaugruppe;

Fig. 11 ein Blockschaltbild einer Meßanordnung mit mehreren Hochfrequenzbaugruppen.

Fig. 1 zeigt ein Blockschaltbild einer Meßanordnung zur Bestimmung der Impulsantwort eines breitbandigen linearen Systems. Die Meßanordnung umfaßt eine Hochfrequenzbaugruppe 1 (HF-Teil). Dem HF-Teil 1 wird von einem Taktgenerator 2 ein hochfrequenter Takt mit einer Frequenz $f_C$ eingespeist. Der hochfrequente Takt muß (mindestens) kurzzeitstabil sein. Wie später detaillierter erläutert, bestimmt der hochfrequente Takt (als einziges) die Bandbreite des zu erzeugenden Testsignals. Innerhalb des HF-Teiles 1 wird der hochfrequente Takt $\boldsymbol{f_C}$ durch eine Taktverteilungseinheit 3 sowohl an die sendeseitigen Bauelemente als auch an die empfängerseitigen Bauelemente verteilt. Um genaue Ergebnisse zu erzielen ist auf eine jitterarme und skew-arme (ohne zeitlichen Versatz), synchrone Taktverteilung Wert zu legen.

Die gesamte Meßanordnung ist streng getaktet, so daß sie Änderungen des hochfrequenten Taktes ohne Zeitverzögerung folgt. Der hochfrequente Takt $f_C$ sollte zumindest während der Messung einer gesuchten Impulsantwort konstant gehalten werden, um "Verschmierungseffekte" zu vermeiden. Eine gewollte Variation des hochfrequenten Taktes bewirkt eine unmittelbare Änderung der Abtastzeitpunkte der Impulsantwort des breitbandigen linearen Systems. Bei der Untersuchung linearer zeitinvarianter Systeme kann dies zur Interpolation zwischen einzelnen Abtastwerten der Impulsantwort ausgenutzt werden. Außerdem ist die bewußte zufällige Änderung der Taktfrequenz $f_C$ und gegebenenfalls zusätzlich die zufällige Änderung der Ordnung $m$ der Maximalfolge (siehe unten) zweckmäßig, um das Erregerspektrum und damit auch das Spektrum der Impulsantwort zu "verschmieren", um eine Ortung des Testsignalsenders zu erschweren oder gegenseitige Störung gleichartiger Systeme zu unterbinden.

Der hochfrequente Takt wird von der Taktverteilungseinheit 3 zu einem Maximalfolgengenerator 4 geführt.

In Fig. 2 ist ein Blockschaltbild des möglichen Aufbaus des Maximalfolgengenerators 4 gezeigt. Andere Prinzipien sind auch denkbar und einsetzbar. Es handelt sich um einen herkömmlichen Maximalfolgengenerator, der im wesentlichen aus einem Schieberegister 5 besteht. Nach bekannten Schaltungsvorschriften sind einzelne Ausgänge des Schieberegisters 5 über Exklusiv-Oder-Gatter 6 an den Eingang des Schieberegisters zurückgekoppelt. Im gezeigten Beispiel besitzt das Schieberegister 5 acht Schiebepositionen, so daß sich eine Ordnung von $m = 8$ ergibt. Die Maximalfolge besteht aus aufeinanderfolgenden Impulsen, die zu einem binären pseudostochastischen Rauschsignal zusammengesetzt sind. Dabei handelt es sich um ein periodisches Signal, wobei sich die Periodenlänge aus der Anzahl der möglichen Kombinationen der Impulsfolgen ergibt und $2^m-1$ beträgt. Die besondere Eigenschaft derartiger Maximalfolgen besteht darin, daß ihre Autokorrelationsfunktion einem Dirac-Stoß sehr nahe kommt.

Fig. 3 zeigt in einem Diagramm den typischen Signalverlauf einer (sehr kurzen; $m=3$) Maximalfolge. Das Testsignal besitzt eine große Bandbreite, wenn die Autokorrelationsfunktion hinreichend kurz ist. Eine Maximalfolge erfüllt diese Forderung. In dem in Fig. 3 gezeigten Maximalfolgenabschnitt ist in der oberen Abbildung eine Periodendauer $T$ der Maximalfolge gekennzeichnet. Ebenfalls ist die Impulsdauer $t_C$ eines Einzelimpulses eingezeichnet. Die Maximalfolge besteht aus einer quasi zufälligen Kombination von $2^m-1$ Einzelimpulsen.

In der unteren Abbildung von Fig. 3 ist das typische Spektrum einer Maximalfolge eingezeichnet, wobei die Position im Spektrum, die der Taktrate $f_C$ entspricht, besonders hervorgehoben ist. An dieser Position befindet sich die erste Nullstelle des Breitbandspektrums. Es gilt der Zusammenhang $f_C=t_C^{-1}$. In der Zeichnung angegeben ist die Breite B (42) des für die Messung nutzbaren Bereichs des Spektrums. Da die äquivalente Abtastrate der Taktrate $f_C$ entspricht, muß $B\leq\frac{1}{2}f_C$ sein, um das Abtasttheorem nicht zu verletzten.

Mit den heutzutage zur Verfügung stehenden Schaltelementen können gemäß dem in Fig. 2 gezeigten prinzipiellen Aufbau Maximalfolgengeneratoren hergestellt werden, die Maximalfolgen mit sehr hohen Frequenzen erzeugen. Zur Anwendung des erfindungsgemäßen Verfahrens und des beschriebenen Gerätes werden beispielsweise Taktfrequenzen von $f_C \leq 10 GHz$ erzeugt und im Maximalfolgengenerator umgesetzt.

Nun zurückkommend auf Fig. 1: Der Maximalfolgengenerator 4 gibt die Maximalfolge $m(t)$ über einen Signalumschalter 7 an einen Eingang eines Ausgangsverstärkers/Entkoppelverstärkers 8 ab. In einfachen Fällen kann der Signalumschalter auch entfallen. Der Ausgangsverstärker 8 besitzt einen negierenden und einen nicht-negierenden Eingang. Mit Hilfe des Ausgangsverstärkers 8 wird die Maximalfolge in geeigneter Weise verstärkt und vom Schieberegister entkoppelt, um an einem Ausgang 10 als Testsignal $x(t)$ an ein breitbandiges lineares System 11 abgegeben zu werden. Das lineare System 11 ist das zu untersuchende Meßobjekt. Die über den Ausgang 10 dem linearen System 11 eingespeiste Maximalfolge durchläuft dieses und unterliegt dabei unterschiedlichen Beeinflussungen, die vom Übertragungsverhalten des Systems abhängig sind. Das lineare System 11 liefert ein Ausgangssignal $y(t)$, welches über einen Eingang 12 dem HF-Teil 1 als Meßsignal eingespeist wird. Das Meßsignal wird einem Eingangsverstärker 13 eingespeist, bei welchem es sich vorzugsweise um einen geregelten Verstärker handelt, der dieses analoge Meßsignal an die Anforderungen der nachfolgenden Schaltungseinheiten anpaßt.

Das verstärkte analoge Meßsignal $y(t)$ stellt noch nicht die Impulsantwort des linearen Systems dar, sondern muß in diese durch Korrelation mit dem Testsignal überführt werden. Das Meßsignal wird einer Abtastschaltung 17 (Sample & Hold oder Track & Hold) zugeführt. Die Abtastschaltung 17 dient der Erfassung der Größe des Antwortsignals zu einem bestimmten Zeitpunkt und der zeitlich stabilen Bereitstellung des ermittelten Wertes an die nachfolgenden Schaltungseinheiten. Die Abtastschaltung 17 wird durch einen Abtasttakt gesteuert, der von einem Taktteiler 18 bereitgestellt wird. Der Abtasttakt wird durch Teilung des hochfrequenten Taktes mit einem Teilungsverhältnis von $2^n$ gebildet. Das Teilungsverhältnis wird so gewählt, daß die Abtastschaltung 17 in dem durch die nachfolgenden Schaltungselemente vorgegebenen Zeitregime betrieben werden kann, um eine korrekte Weiterverarbeitung der bereitgestellten Werte sicherzustellen.

Den abgetasteten und gehaltenen Wert des Meßsignals zum Abtastzeitpunkt liefert die Abtastschaltung 17 an einen Analog-Digital-Wandler 19. Unter Verwendung derzeitig verfügbarer Schaltungselemente wird die Meßgeschwindigkeit der Gesamtanordnung wesentlich von der Arbeitsgeschwindigkeit des Analog-Digital-Wandlers 19 bestimmt. Der von dem Taktteiler 18 bereitgestellte Abtasttakt muß so gewählt werden, daß die dem Analog-Digital-Wandler 19 zugeführten Meßwerte von der Abtastschaltung 17 solange bereitgehalten werden, wie dies die Umsetzung

in einen digitalen Meßwert im Wandler 19 erfordert.

Die Datenerfassungsrate (Meßwerterfassungsgeschwindigkeit) der Meßanordnung kann allein durch Veränderung des Teilungsverhältnisses des Taktteilers 18 angepaßt werden. Dies eröffnet die vorteilhafte Möglichkeit, einen unveränderten HF-Teil 1 mit unterschiedlichen externen Schaltungseinheiten zu kombinieren. Unter technologischen Gesichtspunkten ist es besonders zweckmäßig, alle dem HF-Teil 1 zugeordneten Schaltungseinheiten (Taktverteilungseinheit 3, Maximalfolgengenerator 4, Signalumschalter 7, Ausgangsverstärker 8, Eingangsverstärker 13, Abtastschaltung 17 und Taktteiler 18) als integrierten Schaltkreis aufzubauen, um so eine preiswerte Massenproduktion zu ermöglichen. Dieser integrierte HF-Teil kann dann mit unterschiedlichen externen Schaltungseinheiten kombiniert werden. Wenn für ein gewünschtes Meßgerät eine hohe Meßgenauigkeit und -geschwindigkeit erforderlich sind, können schnelle aber auch teure Analog-Digital-Wandler eingesetzt werden. Sind die Anforderungen bei einem anderen Gerät nicht so hoch, kann der HF-Teil auch mit preiswerteren Wandlern betrieben werden. Nach ähnlichen Kriterien werden auch die sonstigen externen Schaltungseinheiten ausgewählt und mit ein und demselben HF-Teil kombiniert.

Die digitalisierten Meßwerte werden anschließend an einen schnellen Rechenprozessor 20 weitergeleitet. Der schnelle Rechenprozessor 20 kommuniziert mit einem schnellen Speicher 21, beispielsweise einem SRAM oder einem DRAM.

Der schnelle Rechenprozessor 20 dient der Anpassung der Umsetzrate des Analog-Digital-Wandlers an die Verarbeitungsgeschwindigkeit eines nachfolgend angeordneten digitalen Signalprozessors 22 (main processor). Da der Abtasttakt mit dem Teilungsverhältnis $\mathbf{2^n}$ von dem hochfrequenten Takt gewonnen wird und die Periodenlänge der Maximalfolge $\mathbf{2^m-1}$ ist, werden in einer Periode $\frac{2^m-1}{2^n}$ Abtastwerte gewonnen, so daß ein kompletter Satz von digitalen Meßwerten nach $\mathbf{2^n}$ Perioden der Maximalfolge gewonnen wurde.

Die Aufgabe des schnellen Rechenprozessors besteht darin, die hohe Datenerfassungsrate des Analog-Digital-Wandlers 19 an die Verarbeitungsgeschwindikeit des digitalen Signalprozessors 22 anzupassen. Zweckmäßiger Weise geschieht dies über Mittelungsoperationen (Averaging, exponentielle Mittelung, quadratische Mittelung o.ä.), so daß keine Verluste bereits erfaßter Daten auftreten. Der damit erzielbare Dynamikgewinn kann bis zu 10 lg p ***[dB]*** betragen, wenn p die Anzahl von synchronen Mittelungen darstellt. Eine weitere Aufgabe des schnellen Rechenprozessors besteht darin, systematische Fehler in den Abtastwerten zu korrigieren. Zu diesem Zweck bedient man sich Korrekturparameter, die z.B. im Speicher 21 abgelegt wurden. Die Größe der Korrekturparameter wird mittels Kalibriermessungen bestimmt.

Bei der in Fig. 1 gezeigten Ausführungsform ist die Abtastschaltung 17 als Rückführsampler ausgestaltet. Der schnelle Rechenprozessor 20 liefert im Speicher 21 abgelegte digitale Meßwerte an einen Digital-Analog-Wandler 25, der ein analoges Rückführsignal an die Abtastschaltung 17 sendet. Zwar erfordert ein derartiger Rückführsampler 17 einen erhöhten Schaltungsaufwand, jedoch stellt er einen höheren Dynamikbereich zur Verfügung, da bei einem angelegten Rückführsignal jeweils nur die Veränderung des aktuellen Meßwertes gegenüber dem Rückführsignal ermittelt werden muß. Dies führt auch dazu, daß Analog-Digital-Wandler mit einer geringeren Auflösung verwendet werden können, wodurch eine höhere Abtastrate erzielbar ist.

Zum besseren Verständnis der Abtastmöglichkeiten ist in Fig. 4 ein periodisches Meßsignal und das aus Abtastwerten gebildete äquivalente Signal in Diagrammform dargestellt. Im oberen Diagramm ist der Amplitudenverlauf eines möglichen periodischen Meßsignals über die Zeit gezeichnet. Unter anderem aufgrund der erfindungsgemäßen Gestaltung ist es möglich, innerhalb einer Periode T des am Ausgang des linearen Systems abgegebenen Meßsignals mehrere Abtastwerte zu gewinnen. In dem in Fig. 4 gezeigten Fall werden während jeder Periodendauer vier Abtastwerte abgegriffen. In der Darstellung wurden die eingezeichneten Abtastwerte mit kleinen Buchstaben von a bis o durchnumeriert. In der ersten Periode des Meßsignals werden also die Abtastwerte a, b, c und d gewonnen. Um das Abtasttheorem nicht zu verletzen, müssen in der zweiten Periode des Meßsignals weitere Abtastwerte gewonnen werden, nämlich e, f, g und h. Eine vollständige Abtastdauer umfaßt im gezeigten Beispiel also 2 Perioden des Meßsignals. Unter der Voraussetzung der strengen Periodizität des Meßsignals können weitere Abtastwerte, die in den nachfolgenden Perioden gewonnen wurden, zur Erhöhung der Meßgenauigkeit genutzt werden, da durch die Mittelung mögliche Störeinflüsse verringert werden. Im unteren Diagramm von Fig. 4 ist das aus den Abtastwerten gewonnene zusammengesetzte Signal gezeigt. Das Meßsignal wäre bereits durch die Abtastwerte a bis h vollständig repräsentiert. Die weiteren Abtastwerte i bis o dienen der Erhöhung der Meßgenauigkeit.

Die Rückführung vorangegangener Meßwerte zu dem bereits in Bezug auf Fig. 1 genannten Rückführsampler 17 ist prinzipiell unter zwei Aspekten möglich und sinnvoll. Eine Rückführung bringt einen Bandbreite- und Dynamikgewinn, wenn durch geeignete Anordnung der Meßwerte im Speicher sichergestellt ist, daß ein wertemäßig nah beim Meßsignal liegendes Rückführsignal verwendet wird. Einerseits kann der unmittelbar vorangegangene Meßwert der unmittelbar vorangegangenen Periode als Rückführsignal verwendet werden, da aufgrund der Verknüpfung zwischen dem die Maximalfolge steuernden hochfrequenten Takt und dem Abtasttakt die Abtastung von einer Periode zur nächsten Periode exakt um die Taktrate $\boldsymbol{f_C}$ verschoben vorgenommen wird. Bildet man den in einer ersten Periode des Meßsignals gewonnenen ersten Abtastwert und den in der unmittelbar darauffolgenden zweiten Periode gewonnenen ersten Abtastwert in einer äquivalenten Signalperiode ab, so sind diese beiden Abtastwerte zeitlich nur eine äquivalente

Abtastzeit voneinander entfernt. Die äquivalente Abtastzeit ist so gewählt, daß das Abtasttheorem erfüllt ist. Bei der in Fig. 4 gezeigten Abtastung des Meßsignals werden somit die Abtastwerte der ersten Periode als Referenzwerte für die Abtastung der zweiten Periode verwendet; Abtastwert a ist Referenz für Abtastwert e usw.

Andererseits können die Vorteile eines Rückführsamplers auch bei der Durchschnittsbildung über eine Vielzahl von Perioden ausgenutzt werden, wenn als Rückführsignal der zum gleichen Abtastzeitpunkt in einer vorangegangenen Periode gewonnene Meßwert verwendet wird. Bezogen auf den in Fig. 4 dargestellten Fall ist Abtastwert a dann Referenz für Abtastwert h, b ist Referenz für i usw. In diesem Fall ist es sinnvoll, die ermittelten und gegebenenfalls gemittelten Abtastwerte in einem Ringspeicher abzulegen, der $\mathbf{2^m\text{-}1}$ Speicherzellen umfaßt, so daß eine vollständig abgetastete Periode in diesem Ringspeicher abgespeichert ist. Die beiden dargelegten Prinzipien des Rückführsamplings können auch kombiniert eingesetzt werden.

Bei einer anderen Ausführungsform kann auch eine Abtastschaltung ohne Rückführung verwendet werden. Um eine Durchschnittsbildung der Meßwerte zu ermöglichen läßt sich auch in diesem Fall ein Ringspeicher mit $\mathbf{2^m\text{-}1}$ Speicherzellen vorteilhaft einsetzen, wobei innerhalb von mehreren Meßzyklen die zueinander passenden Werte aufsummiert werden und nach einer Division durch die Anzahl der Zyklen einen Mittelwert für den jeweiligen Abtastzeitpunkt bereitstellen.

Der digitale Signalprozessor 22 empfängt die digitalen Meßwerte von dem schnellen Rechenprozessor 20 und führt die weitere Datenverarbeitung durch. Wie bereits beschrieben handelt es sich bei dem Testsignal ***x(t)***, welches dem zu untersuchenden linearen System zugeführt wird, um eine Maximalfolge ***x(t) = m(t)***. Das vom linearen System abgegebene Meßsignal ***y(t)*** stellt noch nicht die Impulsantwort des Systems dar, sondern muß erst in diese umgeformt werden. Dies wird von dem digitalen Signalprozessor 22 durchgeführt, in dem die Kreuzkorrelationsfunktion $\psi_{my}(\tau)$ Zwischen diesen beiden Funktionen bestimmt wird. Prinzipiell geschieht dies nach der folgenden Gleichung:

$$\psi_{my}(\tau)=\int m(t+\tau)\,y(t)\,dt \qquad (4)$$

Da es sich bei den einzelnen Meßwerten um Abtastwerte von periodischen Funktionen handelt, kann die Gleichung (4) auch in der folgenden Form als Matrixgleichung geschrieben werden, hier als Beispiel mit der kürzesten Maximalfolge *(m=2)* :

$$\psi_{my}(\tau)=[y_1 y_2 y_3]\cdot\begin{bmatrix} -1 & 1 & 1 \\ 1 & -1 & 1 \\ 1 & 1 & -1 \end{bmatrix} \qquad (5)$$

(Spalten: $m(t+0)$, $m(t+1)$, $m(t+2)$)

Dieses Matrixprodukt läßt sich schnell berechnen, wenn in bekannter Weise eine Umformung in eine Hadamard-Matrix durchgeführt wird. Dieser Vorgang wird als Hadamard-Transformation bezeichnet. Vorab müssen die Meßwerte in der richtigen Reihenfolge angeordnet werden. Die Hadamard-Transformation wird dann in bekannter Weise ausgeführt. Diesbezüglich wird auf die in der Beschreibungseinleitung genannte Druckschrift verwiesen.

Der digitale Signalprozessor 22 kommuniziert ebenfalls mit dem Speicher 21, in dem die notwendigen Programmbefehle und oder einzelnen Meßwerte abgespeichert werden. vorzugsweise führt der Signalprozessor 22 auch eine Datenreduktion durch, um den Datenstrom zu nachfolgenden Verarbeitungseinheiten zu minimieren.

Die Ergebnisse der Hadamard-Transformation werden von dem digitalen Signalprozessor 22 an eine Schnittstelleneinheit 23 geliefert, die die Verbindung zu weiteren externen Datenverarbeitungsgeräten, wie zum Beispiel einem Personalcomputer, herstellt. Die Schnittstelleneinheit 23 und der schnelle Rechenprozessor 20 sind vorzugsweise mit einer Steuerlogik 26 zu einer Digitaleinheit 27 (Preprocessor) zusammengefaßt und gegebenenfalls schaltungstechnisch integriert. Zur Synchronisation empfängt die Steuerlogik 26 ebenfalls den Abtasttakt vom Taktteiler 18.

Geht man davon aus, daß der Analog-Digital-Wandler 19 den Dynamikbereich der Empfängerseite bestimmt, ergibt sich der Gesamtdynamikbereich der Meßanordnung gemäß der folgenden Gleichung:

$$a[dB] \approx 6b \cdot 10\,\lg(p \cdot (2^m-1)) = 6b + a_{SV} \qquad (6)$$

mit

**$b$** = effektive Bit des AD-Wandlers
**$p$** = Anzahl synchroner Mitteilungen
**$m$** = Ordnung der Maximalfolge
**$a_{SV}$** = Signalverarbeitungsgewinn **[$dB$]**.

Die Meßzeit für eine komplette Impulsantwort beträgt:

$$T_{meß} \approx 2^m t 2^n p$$

Aus den vorgenannten Gleichungen ist ersichtlich, daß je nach Einsatzbereich der Meßanordnung die erzielbare Dynamik und die schaltungstechnischen Anforderungen an den Analog-Digital-Wandler in relativ weiten Grenzen ausgewählt werden können.

Die wesentlichen systematischen Fehler, die in der beschriebenen Meßanordnung auftreten, werden durch Übersprecheffekte und Abweichungen des Testsignals von der gewünschten idealen Form hervorgerufen. Wie dargestellt, basiert das erfindungsgemäße Verfahren auf einer strengen Taktung des Systems und einer stabilen Periodizität des Testsignals. Da diese Forderungen von allen Komponenten der Meßanordnung erfüllt werden müssen, können dadurch zusätzliche aber stabile Signalkomponenten als Übersprechanteile in dem Meßsignal vorhanden sein. Innerhalb einer Periode des Testsignals ändert sich der Zustand des Systems ständig, so daß auch der Übersprechanteil unterschiedlich ist. Jedoch kann der Übersprechanteil durch eine Referenzmessung bestimmt werden, bei der eine Messung ohne angelegtes Testsignal durchgeführt wird.

Die Abweichungen des realen Testsignals von der idealen Form können bestimmt werden, indem eine Referenzmessung an einem bekanntem Meßobjekt durchgeführt wird. Aus dem Unterschied zwischen dem gemessenen Systemverhalten und dem bekannten Systemverhalten des bekannten Meßobjekts kann die Abweichung zwischen realem Testsignal und der idealen Form ermittelt werden. Die ermittelten systematischen Fehler lassen sich in herkömmlicher Weise aus dem realen Meßsignal eliminieren.

Fig. 5 zeigt eine Blockschaltbild eines erweiterten Maximalfolgengenerators 30, der bei einer abgewandelten Ausführungsform der erfindungsgemäßen Meßanordnung eingesetzt wird. Kern dieses erweiterten Maximalfolgengenerators 30 ist der herkömmliche Maximalfolgengenerator 4, der wiederum mit dem hochfrequenten Takt **$f_C$** getriggert wird. Der herkömmliche Maximalfolgengenerator 4 gibt die Maximalfolge **$m(t)$** ab und leitet diese zu einem Multiplizierer 31, der ebenfalls den hochfrequenten Takt empfängt. Das Produkt aus hochfrequentem Takt **$c(t)$** und der Maximalfolge **$m(t)$** wird dann an einen Addierer 32 abgegeben. Gleichzeitig empfängt der Addierer 32 den über ein Dämpfungsglied 33 um den Faktor **$a$** gedämpften hochfrequenten Takt, der hier mit der Funktion **$c(t)$** beschrieben wird. Der hochfrequente Takt bildet somit eine Trägersignal **$c(t)$** , dem die Maximalfolge **$m(t)$** aufgeprägt wird. Die modifizierte Maximalfolge **$n(t)$** ergibt sich gemäß der nachfolgenden Gleichung:

$$n(t) = m(t) \cdot c(t) + a \cdot c(t) \qquad (7)$$

Die in Fig. 5 angegebene Schaltung kann vollständig mit digitalen Schaltelementen und einem Widerstandsnetzwerk aufgebaut werden, so daß sie in den HF-Teil 1 integrierbar ist. Der erweiterte Maximalfolgengenerator 30 gibt ein Testsignal ab, bei welchem das Spektrum der Maximalfolge zu höheren Frequenzen verschoben ist.

Um aussagefähige Meßergebnisse zu erhalten muß sichergestellt sein, daß das Abtasttheorem bei der Durchführung der digitalen Verarbeitungsschritte erfüllt ist. Die Übertragungsfunktion des zu untersuchenden linearen Systems muß daher auf den Frequenzbereich von 0 bis **$f_C/2$** begrenzt sein. Wenn sehr breitbandige Systeme untersucht werden sollen, müssen Maximalfolgen als Testsignale bereitgestellt werden, die mit einer sehr hohen Taktrate **$f_C$** erzeugt wurden. Diese Forderung besteht auch für schmalbandige Systeme, die in einem sehr hohen Frequenzbereich arbeiten. Die technische Realisierung von Maximalfolgen, die mit sehr hohen Taktraten erzeugt wurden, ist jedoch schwierig.

Durch die im Zusammenhang mit Fig. 5 beschriebene Erzeugung einer Verschiebung des Spektrums der Maximalfolge zu höheren Frequenzen läßt sich dieses Problem lösen. Diese Ausgestaltung des Verfahrens kann auf Bandpaßsysteme angewendet werden, die nicht bei tiefen Frequenzen arbeiten. Auf niederfrequente Spektralkomponenten des Testsignals kann bei solchen Systemen verzichtet werden.

Fig. 6 zeigt ein Diagramm der Hüllkurve des Spektrums der modifizierten Maximalfolge $\boldsymbol{n(t)}$. Die Hüllkurve ist gegenüber der Hüllkurve einer herkömmlichen Maximalfolge verschoben, da sie einem Trägersignal hoher Frequenz aufgeprägt wurde. Bei der Frequenz $f_C$ besitzt das Spektrum einen singulären Bereich. Je nach Wahl der Dämpfungskonstante $\boldsymbol{a}$ kann das Spektrum an dieser Stelle erhöht oder erniedrigt werden. Es ist besonders zweckmäßig, wenn die Dämpfungskonstante $\boldsymbol{a}$ so gewählt wird, daß sich ein kontinuierlicher Verlauf der Hüllkurve ergibt. In Fig. 6 ist der Punkt der Singularität bei einer optimal gewählten Dämpfungskonstante $\boldsymbol{a}$ mit der Bezugsziffer 40 gekennzeichnet. Eine Linie 41 stellt den singulären Bereich bei der Frequenz $f_C$ dar. Die äquivalente Abtastrate kann nun beispielsweise mit $3f_C$ festgelegt werden. diese Wahl läßt sich wiederum mit digitalen Schaltelementen einfach realisieren. Anstelle des Teilungsverhältnisses $2^n$ wird nunmehr ein Teilungsverhältnis $3 \div 2^n$ zur Erzeugung des Abtasttaktes aus dem hochfrequenten Takt verwendet. Die Übertragungsfunktion des zu messenden Systems kann in diesem Fall in einem nutzbaren Bereich von $0{,}2f_C$ - $1{,}5f_C$ liegen. Der nutzbare Bereich ist mit einer Linie 42 ebenfalls in Fig. 6 dargestellt.

Um bei der letztgenannten Ausführungsform aus dem Meßsignal die Impulsantwort zu bestimmen, muß wie bei dem zuerst beschriebenen Verfahren, bei welchem die Maximalfolge ohne Trägersignal an den Eingang des zu untersuchenden Systems angelegt wird, eine Kreuzkorrelation zwischen der modifizierten Maximalfolge und dem Meßsignal ermittelt werden. Wie bei dem zuerst beschriebenen Verfahren kann die Korrelation in Form einer Matrizengleichung dargestellt werden. Nachfolgend wird ein einfacher Fall als Beispiel gezeigt, an dem das Prinzip des Signalverlaufs und der zugehörigen Behandlungsvorschrift für die ermittelten Daten deutlich wird.

In Fig. 7 ist der zeitliche Verlauf der interessierenden Signale über eine Periode der Maximalfolge $\boldsymbol{m(t)}$ dargestellt. In der oberen Zeile sind die Zeitpunkte eingezeichnet, an denen eine Abtastung erfolgt. Daß die Abtastwerte tatsächlich nicht innerhalb einer einzigen Periode sondern über $2^n$ Perioden verteilt ermittelt werden, ist für diese Betrachtung nicht entscheidend. Die über mehrere Perioden ermittelten Abtastwerte werden in der richtigen Reihenfolge angeordnet, so daß sie behandelt werden können, als ob sie innerhalb einer Periode bestimmt wurden. In der zweiten Zeile ist das hochfrequente Taktsignal $\boldsymbol{c(t)}$ in seinem zeitlichen Verlauf abgebildet, wobei die Werte zu den einzelnen Abtastzeitpunkten beschriftet wurden. Die Abtastzeitpunkte wurden im dargestellten Beispiel so gewählt, das jede dritte Abtastung auf einer Flanke des Taktsignals liegt, so daß dieses den Signalwert 0 hat. In der dritten Zeile ist der Verlauf der Maximalfolge $\boldsymbol{m(t)}$ über eine Periode dargestellt. Die vierte Zeile zeigt den Signalverlauf des Produktes $\boldsymbol{c(t) \cdot m(t)}$, wobei ebenfalls wieder die einzelnen Signalwerte beschriftet sind. In der untersten Zeile ist der Verlauf des von dem zu untersuchenden System abgegebenen Meßsignal $\boldsymbol{y(t)}$ dargestellt. An den Zeitpunkten der Abtastungen werden einzelne Datenwerte $y_1^A, y_2^0, y_3^B, \ldots$ ermittelt. Aus Gründen der Übersichtlichkeit der nachfolgend beschriebenen Signalbearbeitung, werden alle Signalwerte nacheinander den Gruppen A, 0 und B zugeordnet.

Fig. 8 zeigt die sich ergebende Matrizengleichung, in Bezug auf die in Fig. 7 dargestellten Signale und Abtastzeitpunkte. Ein vollständiger Datensatz für die Berechnung der kompletten Impulsantwort besteht nunmehr aus $\boldsymbol{3 \cdot (2^m - 1)}$ Abtastwerten.

Die obere Matrizengleichung in Fig. 8 entspricht den in Fig. 7 dargestellten Signalen, nachdem die über mehrere Perioden gewonnen Abtastwerte in der richtigen Reihenfolge geordnet wurden. Der Rechenaufwand zur Lösung dieser Matrizengleichung wäre unvertretbar hoch, da die schnelle Hadamard-Transformation auf derartige Matrizen nicht anwendbar ist. Um die Hadamard-Transformation anzuwenden ist eine Umsortierung der Abtastwerte in den Matrizen erforderlich. Dazu werden in einem ersten Schritt die Zeilen der Matrizen in Dreiergruppen zusammengefaßt. Die Anwendung des Gruppierungskriteriums "3" steht in unmittelbarem Zusammenhang mit dem Faktor "3", mit dem das Teilungsverhältnis $2^n$ zur Erzeugung des Abtasttaktes multipliziert wird, wenn die Maximalfolge dem Trägersignal aufgeprägt wird. Um das Verfahren in digitaler Schaltungstechnik zu realisieren, sollte dieser Faktor eine natürliche Zahl sein. Bei abgewandelten Ausführungsformen könnten beispielsweise auch die Faktoren "5" bzw. "7" zur Anwendung kommen. Bei größeren Faktoren erhöht sich jedoch auch der Datenverarbeitungsaufwand, so daß vorzugsweise der Faktor "3" eingesetzt wird.

Zur Umsortierung der Matrizen wird nun die jeweils erste Zeile der Dreiergruppen der Matrizenzeilen verschoben. Die erste Zeile der ersten Gruppe verbleibt daher nach der Neuordnung in der ersten Zeile. Die erste Zeile der zweiten Gruppe wird in die zweite Zeile der neugeordneten Matrizen verschoben, während die erste Zeile der dritten Gruppe in die dritte Zeile verschoben wird. Dann wird die zweite Zeile der ersten Gruppe zur vierten Zeile der neugeordneten Matrix, die gleichzeitig die erste Zeile der zweiten Dreiergruppe in der neuen Matrix darstellt. Die zweite Zeile der zweiten Dreiergruppe in der neuen Matrix ergibt sich aus der zweiten Zeile der zweiten Dreiergruppe der ursprünglichen Matrix, während die dritte Zeile der zweiten Dreiergruppe der neuen Matrix, der zweiten Zeile der dritten Dreiergruppe der ursprünglichen Matrix entspricht. Dieser Verschiebealgorithmus wird mit allen Zeilen der ursprünglichen Matrix ausgeführt. Das Ergebnis ist als zweite Matrizengleichung in Fig. 8 dargestellt. Damit die Gleichung weiterhin gültig ist, müssen auch die einzelnen Werte des Vektors des Meßsignals umsortiert werden, wie dies ebenfalls in Fig. 8 ersichtlich ist. Die Abtastwerte werden dabei ebenfalls in Dreiergruppen eingeteilt, wobei immer der erste, der zweite bzw. der dritte Wert jeder einzelnen Dreiergruppe in der zweiten in Fig. 8 dargestellten Gleichung zusammengefaßt sind.

Im nächsten Umformungsschritt wird eine erneute Umsortierung der in den Matrizen enthaltenen Werte vorgenommen, wobei diesmal die Spalten in Dreiergruppen zusammengefaßt werden. Der Sortieralgorithmus entspricht ansonsten dem für die Zeilen erläuterten. Das Ergebnis ist als dritte Gleichung in Fig. 8 gezeigt. In den beiden Matrizen können nun Untermatrizen zusammengefaßt werden, die jeweils drei Zeilen und drei Spalten umfassen. Einzelne Untermatrizen sind in Fig. 8 durch eine zusätzliche Umrandung beispielhaft hervorgehoben. Es ergeben sich in jeder einzelnen Matrix sechs Untermatrizen, die die relevanten Abtastwerte enthalten, und drei Untermatrizen, die nur den Wert 0 enthalten und somit in der weiteren Datenverarbeitung nicht berücksichtigt werden müssen. Die sechs relevanten Untermatrizen der unteren Matrix können nunmehr mit einer herkömmlichen Hadamard-Transformation bearbeitet werden. Eine zusätzliche Vereinfachung ergibt sich daraus, daß eine Untermatrix ***M2*** in eine Untermatrix -***M1*** umgeformt werden kann, wenn die dritte Spalte der Untermatrix ***M2*** an die Stelle der ersten Spalte verschoben wird und die beiden verbleibenden Spalten auf die Positionen zwei und drei rücken. Die sechs Untermatrizen der rechten Matrix besagen, daß lediglich alle Meßwerte der jeweiligen Gruppe A, 0 oder B zu addieren sind. Nachdem alle Matrixoperationen durchgeführt wurden, sind die Ergebnisvektoren wieder in ihrer natürlichen Reihenfolge anzuordnen und ergeben die gesuchte Impulsantwort.

Für den Fall, daß das Spektrum des Meßsignals $\boldsymbol{y(t)}$ auf $\boldsymbol{0{,}5f_C},\ldots,\boldsymbol{1{,}5f_C}$ begrenzt ist, zeigt Fig. 9 ein weiteres Blockschaltbild eines Datenverarbeitungsabschnitts zur Meßdatenverarbeitung unter Verwendung der modifizierten Maximalfolge gezeigt. Die digitalisierten und ggf. einer Durchschnittsbildung unterzogenen Abtastwerte werden einem Sortierer 50 zugeführt, der ggf. in dem digitalen Signalprozessor integriert sein kann. Durch den Sortierer 50 werden die Abtastwerte in ihrer natürlichen Reihenfolge angeordnet, so daß ein reelles Bandpaßsignal erhalten wird, dessen Spektrum ein komprimiertes Abbild des Originalspektrums ist. Die Daten werden anschließend einem ersten Quadraturmodulator 51 eingespeist, der aus diesen ein analytisches Tiefpaßsignal formt, dieses in einen Realanteil und einen Imaginäranteil trennt und diese beiden Anteile jeweils einem zugeordneten Dezimator (Datenreduktionseinheit) 52 zuführt. Der Dezimator führt eine Datenreduktion aus, die darin begründet liegt, daß nur $\frac{2}{3}$ des gültigen Spektralbereichs auch tatsächlich mit Meßwerten versehen wird. Anschließend werden die relevanten Daten der Hadamard-Transformation 53 unterzogen. Nach der Hadamard-Transformation wird durch einen Interpolator 54 der ursprüngliche Datenumfang wiederhergestellt, so daß in dem sich anschließenden zweiten Quadraturmodulator 55 aus den Anteilen des komplexen Signals wieder ein reelles Signal gebildet wird, dessen Verlauf der Kreuzkorrelationsfunktion zwischen dem Meßsignal und dem Testsignal entspricht.

Fig. 10 zeigt ein Blockschaltbild einer möglichen Ausführungsform einer integrierten Hochfrequenzbaugruppe 1 (HF-Teil). Die einzelnen Baugruppen des HF-Teils 1 sind digital aufgebaut, wodurch eine einfache Integration möglich wird. Ziel dieser integrierten Lösung ist unter anderem die Verwendung von Standard-HF-Teilen in einem vielkanaligen Meßgerät. Der hochfrequente Takt $f_C$ wird dem HF-Teil an einem Eingang 70 zugeführt. Der Frequenz $f_C$ des hochfrequenten Taktes kann an die spezifische Meßaufgabe angepaßt werden. Der Takt $f_C$ wird über ein Schalttor 71 weitergeleitet, welches ein Schaltsignal von einem Taktzuschalteingang 72 empfängt und im geöffneten Zustand den Takt an die übrigen Baugruppen weiterleitet. Um saubere Schaltflanken zu gewährleisten durchläuft der Takt $f_C$ eine Taktregenerationseinheit 73. Von der Taktregenerationseinheit 73 wird der Takt zum Maximalfolgengenerator 4, dem Taktteiler 18 und zu einem Taktausgang 74 verteilt. Weiterhin ist in dem HF-Teil der Ausgangsverstärker 8 integriert, der bei der hier gezeigten Ausführungsform die Maximalfolge direkt vom Maximalfolgengenerator 4 empfängt. Ein Signalumschalter ist hier nicht vorgesehen. Anstelle dessen besitzt der Maximalfolgengenerator 4 einen Freigabeeingang 75, der eine Start/Stop-Signal von einer Synchronisationsschaltung 76 empfängt. Der Taktteiler 18 erzeugt aus dem hochfrequenten Takt $f_C$ durch eine Teilung im Verhältnis $1{:}2^n$ den Abtasttakt, welchen er an die Synchronisationsschaltung 76 und an einen Abtastausgang 77 liefert. Das Teilungsverhältnis des Taktteilers ist vorzugsweise einstellbar, um bei verändertem hochfrequenten Takt den in den anderen Baugruppen benötigten spezifischen Abtasttakt bereitzustellen. Die Generierung des Start/Stop-Signals für den Maximalfolgengenerator 4 wird in der Synchronisationsschaltung 76 in Reaktion auf ein externes Start/Stop-Signal ausgeführt, welches an einem Start/Stop-Eingang 78 dem HF-Teil eingespeist wird. Die verstärkte Maximalfolge wird an den Testsignalausgang 10 vom HF-Teil abgegeben. Ebenfalls ist in den HF-Teil der Eingangsverstärker 13 integriert, der das Meßsignal am Eingang 12 empfängt. Das verstärkte Meßsignal wird zur Abtastschaltung 17 geliefert. Die Abtastschaltung 17 stellt den abgetasteten Meßwert an einem Meßwertausgang 79 stabil zur Verfügung. Da die dargestellte Ausführungsform eine Abtastschaltung mit Rückführung verwendet, wird über einen Rückführeingang 80 ein vorangegangener Abtastwert an die Abtastschaltung zugeführt. Weiterhin ist ein Verstärkungssteuereingang 81 vorgesehen, mit welchem die Verstärkung des Eingangsverstärkers 13 geregelt werden kann.

Um eine möglichst einfache Kaskadierung mehrerer HF-Teile zu ermöglichen, kommt es darauf an, daß möglichst wenige HF-Leitungen zwischen den einzelnen HF-Teilen geführt werden, um Störeinflüsse gering zu halten. Es ist wünschenswert, daß Steuersignale und dergleichen wenig kritischen Zeitbezug besitzen, um einfache Leitungen und eine unkomplizierte Ansteuerelektronik verwenden zu können. Zeitkritische Signale sind das hochfrequente Taktsignal, der Abtasttakt, ein Synchronisationssignal, mit welchem der Beginn einer neuen Maximalfolge festgelegt wird, sowie das Testsignal und das Meßsignal. Da gemäß der vorgeschlagenen Ausgestaltung der HF-Teil als integrierter Baustein ausgebildet ist, kann dieser Baustein in unmittelbarer Nähe eines HF-Sensors (z.B. einer Antenne) angeordnet sein, so daß kaum Probleme mit dem Testsignal und dem Meßsignal auftreten.

Bei Anwendung des in Fig. 10 dargestellten Schaltungsprinzips verbleibt als kritische Signalleitung lediglich die Taktsignalleitung, die innerhalb des HF-Teils zwischen dem Takteingang 70 und dem Taktausgang 74 verläuft und von einem integrierten HF-Teil zu dem nächsten integrierten HF-Teil weitergeführt werden muß.

Fig. 11 zeigt ein Blockschaltbild einer erfindungsgemäßen Meßanordnung unter Verwendung mehrerer gleichartiger Hochfrequenzbaugruppen 1 (HF-Teile). Im dargestellten Beispiel soll ein lineares System 11 mit drei Eingängen $\boldsymbol{x_1}$, $\boldsymbol{x_2}$ und $\boldsymbol{x_3}$ und drei Ausgängen $\boldsymbol{y_1}$, $\boldsymbol{y_2}$ und $\boldsymbol{y_3}$ durch Einspeisung von Testsignalen und Auswertung der abgegebenen Ausgangssignale untersucht werden. Somit kommen drei HF-Teile 1 zur Anwendung, die jeweils Maximalfolgen an die Eingänge des Systems 11 abgeben. Alle drei HF-Teile empfangen die Meßsignale von den Ausgängen des linearen Systems. Die Hochfrequenzbaugruppen 1 werden von einem gemeinsamen Taktgenerator 2 mit einem hochfrequenten Takt $\boldsymbol{f_C}$ versorgt. Wie in Bezug auf Fig. 10 erläutert, wird der Takt durch jedes HF-Teil durchgeschleift, so daß die fett gezeichnete Taktleitung die einzige Synchronisationsleitung der Meßanordnung darstellt. Am Ende dieser Leitung ist ein Abschlußwiderstand 82 angeordnet.

Jedem HF-Teil 1 ist ein Analog-Digital-Wandler 19 zugeordnet, der die digitalisierten Abtastwerte an eine gemeinsame Digitaleinheit 27 und den nicht gesondert eingezeichneten digitalen Signalprozessor liefert. Ebenso ist jedem HF-Teil ein Digital-Analog-Wandler 25 zugeordnet, der die Rückführsignale an den jeweiligen Rückführeingang 80 liefert. Zusätzlich ist eine Meßablaufsteuerung 90 vorgesehen, die über die Start/Stop-Eingänge 78 auf die einzelnen HF-Teile 1 einwirkt. Die Meßablaufsteuerung 90 besitzt eine nicht eingezeichnete Kopplung zur Steuerlogik 26 und zum gemeinsamen Signalprozessor 22, um auf Steuerbefehle dieser Schaltungseinheiten zu reagieren. Sofern eine Ausführungsform mit Signalumschaltern eingesetzt wird, übernimmt die Meßablaufsteuerung auch die Ansteuerung der Signalumschalter.

Wie in Fig. 10 eingezeichnet, befindet sich vor der Taktregenerationseinheit 73 ein Schalttor 71, welches über den Taktzuschalteingang 72 steuerbar ist. Im Regelfall ist das Schalttor 71 geöffnet, so daß das Taktsignal ohne weiteres durchgeleitet wird. Lediglich der erste HF-Teil in der Kettenanordnung empfängt ein Steuersignal von der Meßablaufsteuerung 90 über den Taktzuschalteingang 72, durch welches das Schalttor 71 zu einem definierten Meßstart-Zeitpunkt geöffnet wird. Verzögerungen, die das Taktsignal auf dem Signallaufweg durch die aneinandergereihten HF-Teile erfährt, können durch eine Kalibrierungsmessung aus dem Meßergebnis herausgerechnet werden, so daß sie sich nicht nachteilig auf die Genauigkeit des Meßergebnisses auswirken.

Wie es in Fig. 11 gezeigt ist, können mehrere Kanäle an eine gemeinsame Digitaleinheit angeschlossen sein. Sofern hohe Datenraten erwünscht sind, kann aber auch jedem Meßkanal ein eigener Pre-Prozessor zugeordnet sein. Gegebenenfalls können auch mehrere digitale Signalprozessoren parallel betrieben werden, wodurch die Arbeitsgeschwindigkeit weiter gesteigert werden kann.

Um Messungen an sogenannten MiMo-Systemen (Multi Input, Multi Output) ausführen zu können, ist es erforderlich daß die an den verschiedenen Eingängen angelegten Testsignale weitgehend unkorreliert sind. Wenn wie im dargestellten Beispiel Maximalfolgen gleicher Länge als Testsignale verwendet werden, sind diese zueinander immer korreliert, so daß eine gleichzeitige Erregung aller Eingänge nicht erlaubt wäre. Um das erfindungsgemäße Verfahren auch für derartige Systeme anwenden zu können, muß die Polarität der Testsignale an den einzelnen Eingängen des zu untersuchenden Systems in einem geeigneten Zeitregime geändert werden. Dazu dienen bei der in Fig. 1 dargestellten Ausführungsform die Signalumschalter 7, die in jeden HF-Teil integriert sind. Der Signalumschalter ermöglicht die Abgabe der Maximalfolge mit positiver oder negativer Polarität und besitzt eine dritte Schaltstellung, in welcher kein Testsignal vom HF-Teil abgegeben wird. Die letztgenannte Funktion kann auch durch Abschaltung des Maximalfolgengenerators mit Hilfe eines Start/Stop-Eingangs (enable) ausgeführt werden, wie dies bei der Ausführungsform nach den Fig.n 9 und 10 erfolgt.

Nachfolgend wird erläutert, wie die Umschaltungen der Signalumschalter bzw. die Start/Stop-Signale zu steuern sind. Dazu wird ein System betrachtet, welches $\boldsymbol{K}$ Eingänge besitzt, an die Testsignale $\boldsymbol{x_k(t)}$ mit $\boldsymbol{k=1...K}$ angelegt werden. Die an den $L$ Ausgängen des Systems abgenommenen Meßsignale sind $\boldsymbol{y_l(t)}$ mit $\boldsymbol{l=1...L}$. die einzelnen Signale lassen sich wie nachfolgend gezeigt als Vektoren schreiben:

$$\mathbf{x}(t) = \begin{bmatrix} x_1(t) \\ x_2(t) \\ x_3(t) \\ \vdots \\ x_K(t) \end{bmatrix} \quad (8) \qquad \mathbf{y}(t) = \begin{bmatrix} y_1(t) \\ y_2(t) \\ y_3(t) \\ \vdots \\ y_L(t) \end{bmatrix} \quad (9)$$

Es werden dann mindestens ***K*** Messungen durchgeführt, wobei immer andere Kombinationen der Testsignale an den Eingängen angelegt werden. Alle Testsignale und alle Meßsignale werden in Matrizen zusammengefaßt:

$$\mathbf{u}(t) = \left[\mathbf{x}^{(1)}(t)\ \mathbf{x}^{(2)}(t)\ \mathbf{x}^{(3)}(t)\ \cdots\ \mathbf{x}^{(K)}(t)\right] = \begin{bmatrix} x_{11}(t) & x_{12}(t) & \cdots & x_{1K}(t) \\ x_{21}(t) & x_{22}(t) & \cdots & x_{2K}(t) \\ \vdots & \vdots & \ddots & \vdots \\ x_{K1}(t) & x_{K2}(t) & \cdots & x_{KK}(t) \end{bmatrix} \quad (10)$$

$$\mathbf{v}(t) = \left[\mathbf{y}^{(1)}(t)\ \mathbf{y}^{(2)}(t)\ \mathbf{y}^{(3)}(t)\ \cdots\ \mathbf{y}^{(K)}(t)\right] = \begin{bmatrix} y_{11}(t) & y_{12}(t) & \cdots & y_{1K}(t) \\ y_{21}(t) & y_{22}(t) & \cdots & y_{2K}(t) \\ \vdots & \vdots & \ddots & \vdots \\ y_{L1}(t) & y_{L2}(t) & \cdots & y_{LK}(t) \end{bmatrix} \quad (11)$$

Hierbei ist **u(*t*)** die Testsignalmatrix und **v(*t*)** die Meßsignalmatrix, aus denen die beiden Korrelationsmatrizen $\psi_{uu}(\tau)$ und $\psi_{uv}(\tau)$ berechnet werden:

$$\psi_{uu}(\tau) = \int u(t) u^T (t+\tau) dt \quad (12)$$

$$\psi_{uv}(\tau) = \int v(t) u^T (t+\tau) dt \quad (13)$$

Die Faltung dieser beiden Matrizen ergibt schließlich die gesuchte Matrix der Impulsantworten **g(*t*)** des untersuchten Systems:

$$\psi_{uv}(t) = \int g(\tau) \psi_{uu}(t-\tau) d\tau \quad (14)$$

Um die einzelnen Impulsantworten zu ermitteln, muß die Gleichung (14) nach ***g(t)*** umgestellt werden, was mit vertretbarem Aufwand nur möglich ist, wenn die Testsignale geeignet ausgewählt werden. Die verwendeten Testsignale sind optimal aufeinander abgestimmt, wenn ihre Korrelationsmatrix eine Diagonalmatrix ist, deren Diagonalelemente Dirac-Funktionen sind.

$$\psi_{uv,opt}(\tau) = \delta(\tau) \cdot D \quad (15)$$

mit

$$\mathbf{D}=\begin{bmatrix} \sum^{K} x_{1,eff}^2 & 0 & \cdots & 0 \\ 0 & \sum^{K} x_{2,eff}^2 & \cdots & 0 \\ \vdots & \vdots & \ddots & \vdots \\ 0 & 0 & \cdots & \sum^{K} x_{K,eff}^2 \end{bmatrix}$$

$$\sum^{K} x_{k,eff}^2$$

ist die Summe der Leistungen aller am Eingang $\boldsymbol{k}$ angelegten Testsignale.

Sofern für die Anzahl $\boldsymbol{K}$ der Eingänge des zu messenden Systems eine Hadamardmatrix existiert, ist es unter ausschließlicher Verwendung identischer Maximalfolgen $\boldsymbol{m(t)}$ möglich, eine optimale Korrelationsmatrix $\psi_{uu,opt}(\tau)$ der Testsignale zu bilden. Es ist in diesem Fall nötig, bei den $\boldsymbol{K}$ Messungen die Polarität der Maximalfolgen entsprechend der Bildungsvorschrift einer Hadamardmatrix zu variieren.

Nachfolgend soll am Beispiel der Messung eines Systems mit zwei Eingängen und drei Ausgängen gezeigt werden, wie die Signalumschalter der zu verwendenden drei Hochfrequenzbaugruppen angesteuert werden müssen. Das beispielhafte System ist durch sechs Impulsantworten $\boldsymbol{g_{k,l}(t)}$ charakterisiert. Für den Fall, daß gleichzeitig zwei Signale am Eingang anliegen, ergeben sich die Ausgangssignale als Faltungsprodukt wie folgt:

$$\begin{bmatrix} y_1(t) \\ y_2(t) \\ y_3(t) \end{bmatrix} = \begin{bmatrix} g_{11}(t) & g_{12}(t) \\ g_{21}(t) & g_{22}(t) \\ g_{31}(t) & g_{32}(t) \end{bmatrix} * \begin{bmatrix} x_1(t) \\ x_2(t) \end{bmatrix} \qquad (16)$$

Werden nachfolgend ein zweites (drittes ......) mal Signale angelegt, ergibt sich (die Abhängigkeit von der Zeit wird im weiteren stillschweigend vorausgesetzt):

$$\begin{bmatrix} y_{11} & y_{12} \\ y_{21} & y_{22} \\ y_{31} & y_{32} \end{bmatrix} = \begin{bmatrix} g_{11} & g_{12} \\ g_{21} & g_{22} \\ g_{31} & g_{32} \end{bmatrix} * \begin{bmatrix} x_{11} & x_{12} \\ x_{21} & x_{22} \end{bmatrix} \qquad (17)$$

↑ 1. Messung ↑ 2. Messung ↑ Das System ändert die Eigenschaften nicht ↑ 1. Messung ↑ 2. Messung

Unter der Voraussetzung, daß als Testsignale ausschließlich Maximalfolgen ***m(t)*** an allen Eingängen verwendet werden, die mit positiver oder negativer (invertierter) Polarität angelegt oder abgeschaltet werden, kann die in der Gleichung (17) gekennzeichnete Erregermatrix wie folgt geschrieben werden:

$$\begin{bmatrix} x_{11} & x_{12} \\ x_{21} & x_{22} \end{bmatrix} = m(t) \cdot \begin{bmatrix} a_{11} & a_{12} \\ a_{21} & a_{22} \end{bmatrix} \quad \text{mit} \quad a_{ij} \in \{-1, 0, 1\} \qquad (18)$$

Schreibt man die Gleichungen (17) und (18) in Matrixform ergibt sich:

$$\mathrm{v}(t) = \mathrm{g}(t) * \mathrm{u}(t) \qquad (19)$$

$$\mathrm{u}(t) = m(t) \cdot \mathrm{A} \qquad (20)$$

**A** ist die Schaltmatrix, in der die Schaltzustände für die Signalumschalter in den einzelnen Hochfrequenzbaugruppen enthalten sind.

Im nächsten Schritt wird aus der Gleichung (19) die Kreuzkorrelierte gebildet. Daraus ergibt sich:

$$\psi_{vu}(\tau) = \int \mathrm{v}(t)\mathrm{u}^T(t+\tau)dt = \mathrm{g}(t) * \int \mathrm{u}(t) \cdot \mathrm{u}^T(t+\tau)dt \qquad (21)$$

wobei

$$\int \mathrm{u}(t) \cdot \mathrm{u}^T(t+\tau)dt = \mathrm{A} \cdot \mathrm{A}^T \cdot \int m(t) \cdot m(t+\tau)d\tau$$

$$\approx \mathrm{A} \cdot \mathrm{A}^T \cdot \delta(\tau)$$

daraus ergibt sich

$$\psi_{vu}(\tau) \approx \mathrm{g}(\tau) \cdot \mathrm{A} \cdot \mathrm{A}^T \qquad (22)$$

Wobei $\psi_{vu,}(\tau)$ aus den Meßwerten berechnet werden kann, während $\mathbf{g}(\tau)$ gesucht ist. Nach Umstellung der Gleichung (22) ergibt sich:

$$g(\tau)\approx\psi_{vu}(\tau)\cdot(A\cdot A^{T})^{-1} \tag{23}$$

Voraussetzung dieser Umstellung ist, daß $\mathbf{A}\cdot\mathbf{A}^{T}$ nicht singulär ist. Die besten Ergebnisse werden in einer durchzuführenden Messung erzielt, wenn

$$A\cdot A^{T}=D \tag{24}$$

wobei **D** eine Diagonalmatrix ist;

bzw. allgemein wenn **A** eine orthogonale Matrix ist.

Diese Bedingung ist beispielsweise erfüllt, wenn bei jeder Messung immer nur an einen Eingang eine Maximalfolge angelegt wird, so daß die Schaltmatrix **A** bei einem System mit vier Eingängen wie folgt gestaltet ist:

$$\mathbf{A}=\begin{bmatrix}1&0&0&0\\0&1&0&0\\0&0&1&0\\0&0&0&1\end{bmatrix}=\mathbf{D}=\mathbf{I} \tag{25}$$

Da die Ausführungsform, bei welcher immer nur an einem Eingang des mehrkanaligen linearen Systems ein Testsignal angelegt wird, den besonderen Vorteil besitzt, daß ein definierter Beginn des Testsignals festgestellt werden kann, sollen nachfolgend einige Erläuterungen zu den schaltungstechnischen Besonderheiten dieser Ausführungsform gegeben werden. Die als Testsignal zu verwendende Maximalfolge soll mit der Genauigkeit einer Taktflanke des hochfrequenten Taktes gestartet werden. Um auch die Steuerung des Meßablaufs in klassischer Digitalschaltungstechnik auszuführen, sind besondere Lösungen erforderlich, da die vorgenannte Forderung durch herkömmliche Schaltungsgestaltungen nicht erfüllt werden kann. Deshalb wird gemäß Fig. 10 das Start/Stop-Signal von der Synchronisationsschaltung 76 an den Freigabeeingang 75 des Maximalfolgengenerators 4 geliefert. Da der Abtasttakt unmittelbar aus dem hochfrequenten Takt abgeleitet wird, besitzt er die gleiche Präzision, so daß der Abtasttakt als Steuertakt für die Synchronisationsschaltung 76 genutzt werden kann, welche das Start/Stop-Signal nur zu exakt festgelegten Zeitpunkten zu dem Maximalfolgengenerator 4 leitet. Das von außen über den Start/Stop-Eingang 78 zugeführte Steuersignal kann daher zwischen zwei Abtasttakten auf einen stabilen Zustand einschwingen. Als Einschwingzeit steht ein Zeitraum bis zur Länge der Periodendauer des Abtasttaktes zur Verfügung, so daß mit herkömmlicher digitaler Schaltungstechnik gearbeitet werden kann.

Sollen an alle Eingänge Maximalfolgen angelegt werden, muß bei jeder Messung die Polarisation der Maximalfolge geändert werden. Dabei ist es besonders zweckmäßig, wenn die Schaltmatrix eine Hadamardmatrix ist. Für den Fall, daß vier Eingänge an einem zu untersuchenden System vorhanden sind, sieht die Schaltmatrix wie folgt aus:

$$\mathbf{A}=\mathbf{H}(4)=\begin{bmatrix}1&-1&-1&1\\1&1&-1&-1\\1&-1&1&-1\\1&1&1&1\end{bmatrix}. \tag{26}$$

wobei $\mathbf{A}\cdot\mathbf{A}^{T}=\mathbf{D}=4\cdot\mathbf{I}$ (**I** *ist die Einheitsmatrix*).

Es ist besonders vorteilhaft, die Schaltmatrix als Hadamard-Matrix auszulegen, da der erreichbare Störabstand bei einem Anlegen von Testsignalen an allen Eingänge wesentlich höher ist, als wenn je Messung nur an einen Eingang ein Testsignal angelegt wird.

## Patentansprüche

**1.** Verfahren zur Bestimmung der Impulsantwort ***g*(*t*)** eines breitbandigen linearen Systems, die folgenden Schritte umfassend:

- Erzeugung eines hochfrequenten Taktes mit einer Frequenz $f_C \geq 100$ MHz;
- Erzeugung einer periodischen Maximalfolge ***m*(*t*)** mit einer Ordnung ***m*** und einer Periodenlänge von $2^m-1$ Impulsen des hochfrequenten Taktes;
- Verstärkung und Zuführung der periodischen Maximalfolge ***m*(*t*)** als Testsignal ***x*(*t*)** zum breitbandigen linearen System;
- Empfang und Verstärkung des Antwortsignals des Systems als Meßsignal ***y*(*t*)**, um es in seiner Amplitude an die nachfolgenden Schaltungseinheiten anzupassen;
- Bereitstellung eines Abtasttaktes, der aus dem hochfrequenten Takt in einem Teilungsverhältnis $2^n$ gebildet wird;
- Abtastung des analogen Meßsignals über mindestens $2^n$ Perioden und Bereitstellung analoger Abtastwerte, wobei die Abtastzeitpunkte durch den Abtasttakt vorgegeben sind und je Periode des Meßsignals $\frac{2^m-1}{2^n}$ Abtastwerte gewonnen werden;
- Umwandlung der analogen Abtastwerte in digitale Abtastwerte die zu einem digitaten Meßsignal zusammengesetzt werden;
- Ermittlung der Impulsantwort ***g*(*t*)** durch Berechnung der Kreuzkorrelation $\psi$ zwischen dem Testsignal und dem digitalen Meßsignal unter Durchführung einer schnellen Hadamard-Transformation (FHT) unter Berücksichtigung der Anordnung der digitalen Abtastwerte.

**2.** Verfahren nach Anspruch 1, **dadurch gekennzeichnet, daß** die Frequenz $f_C$ des hochfrequenten Taktes einstellbar ist.

**3.** Verfahren nach Anspruch 1 oder 2, **dadurch gekennzeichnet, daß** Abtastwerte zwischengespeichert und bei der Abtastung nachfolgender Werte des Meßsignals als Referenzwert verwendet werden, wobei die Abtastzeitpunkte auf verschiedene Perioden verteilt sind, jedoch projiziert auf eine Periode betrachtet, nicht mehr als eine Periodenlänge $t_C$ des hochfrequenten Taktes voneinander beabstandet sind.

**4.** Verfahren nach einem der Ansprüche 1 bis 3, **dadurch gekennzeichnet, daß** die Maximalfolge ***m*(*t*)** einem hochfrequenten Trägersignal ***c*(*t*)** aufgeprägt wird, um das Spektrum der Maximalfolge zu verschieben und eine modifizierte Maximalfolge ***n*(*t*)** zur Verfügung zu stellen.

**5.** Verfahren nach Anspruch 4, **dadurch gekennzeichnet, daß**

- der Abtasttakt mit dem Teilungsverhältnis $2^n \div i$ gebildet wird, wobei ***i*** eine ungerade Zahl größer als 1 ist ($i=2n+1$; $i > 1$);
- die Werte des Taktsignals zu den Abtastzeitpunkten in einer Matrix ***c*(*t*)** angeordnet werden;
- die digitalen Abtastwerte mit dem hochfrequenten Taktsignal multipliziert und in einer Matrix ***m*(*t*)·*c*(*t*)** angeordnet werden;
- die beiden Ausgangsmatrizen ***m*(*t*)·*c*(*t*)** und ***c(t)*** einer Umsortierung unterzogen werden, wobei in jeder Matrix
    - die Zeilen zu Zeilengruppen mit je ***i*** Zeilen zusammengefaßt werden,
    - eine Zwischenmatrix gebildet wird, in der die Zeilen aufsteigend geordnet werden, primär nach ihrer Position in den Zeilengruppen und sekundär nach der Position der Zeilengruppe in der Ausgangsmatrix,
    - die Spalten der Zwischenmatrix zu Spaltengruppen mit je ***i*** Spalten zusammengefaßt werden,
    - eine Zielmatrix aus der Zwischenmatrix gebildet wird, in der die Spalten aufsteigend geordnet werden, primär nach ihrer Position in den Spaltengruppen und sekundär nach der Position der Spaltengruppe in der Zwischenmatrix;
- die Korrelation durch Lösung der Matrizengleichung mit den Zielmatrizen unter Anwendung der Hadamard-Transformation und einfacher Additionen durchgeführt wird.

**6.** Verfahren nach einem der Ansprüche 1 bis 5 zur Bestimmung der Impulsantworten eines breitbandigen linearen Systems mit ***K*** Eingängen (***K***>1) und/oder ***L*** Ausgängen **(*L*>1)**, **dadurch gekennzeichnet, daß**

- gleichzeitig oder nacheinander an jeden Eingang des System eine Maximalfolge als Testsignal ***x*(*t*)** angelegt wird;
- an jedem Ausgang des Systems ein Meßsignal ***y*(*t*)** abgegriffen wird;
- mindestens ***K*** Messungen ausgeführt werden, mit jeweils anderen Kombinationen der Testsignale ***x*(*t*)** an den Eingängen;
- alle Impulsantworten ***g*(*t*)** des Systems ermittelt werden.

**7.** Verfahren nach Anspruch 6, **dadurch gekennzeichnet, daß** an die Eingänge positive oder negative polarisierte Maximalfolgen angelegt werden oder nicht angelegt werden, und zwar nach einem Kombinationsschema A, welches eine orthogonale Matrix, insbesondere eine Hadamardmatrix darstellt.

**8.** Meßanordnung zur Bestimmung der Impulsantwort ***g*(*t*)** eines breitbandigen linearen Systems (11) umfassend:

- einen Taktgenerator (2), der einen hochfrequenten Takt $f_C$ bereitstellt;
- eine Hochfrequenzbaugruppe (1) (HF-Teil) bestehend aus

  - einem Maximalfolgengenerator (4), der von dem hochfrequenten Takt $f_C$ gesteuert wird und eine Maximalfolge ***m*(*t*)** der Ordnung ***m*** liefert,
  - einem Ausgangsverstärker (8), der die Maximalfolge empfängt und sie als Testsignal an das breitbandige lineare System (11) abgibt,
  - einem regelbaren Eingangsverstärker (13), der ein Antwortsignal von dem breitbandigen linearen System (11) als Meßsignal ***y*(*t*)** empfängt und verstärkt, um dieses auf die nachfolgenden Schaltungseinheiten anzupassen,
  - einem digitalen Taktteiler (18), der den hochfrequenten Takt $f_C$ in einem vorbestimmten Verhältnis $\mathbf{2}^n$ teilt und einen Abtasttakt zur Verfügung stellt, und
  - einer Abtastschaltung (17), die vom Abtasttakt gesteuert wird und das vom Eingangsverstärker (13) empfangene Meßsignal ***y*(*t*)** abtastet;

- einen Analog-Digital-Wandler (19), der von der Abtastschaltung (17) analoge Abtastwerte empfängt und diese in digitale Abtastwerte umsetzt;
- eine Recheneinheit (20, 21, 22), die die einzelnen digitalen Abtastwerte zu einem digitalen Meßsignal zusammensetzt und aus diesem und dem Testsignal unter Anwendung einer schnellen Hadamard-Transformation die Impulsantwort berechnet; und
- eine Schnittstelleneinheit (23), die die Impulsantwort an nachfolgende Anzeige- und/oder Speicher- und/oder Datenverarbeitungseinheiten abgibt.

**9.** Meßandordnung nach Anspruch 8, **dadurch gekennzeichnet, daß** die Hochfrequenzbaugruppe als integrierte Schaltung aufgebaut ist, umfassend:

- einen Takteingang (70), an dem der hochfrequente Takt $f_C$ eingespeist wird;
- ein Schalttor (71) mit einem Taktzuschalteingang (72), . welches die Durchschaltung des hochfrequenten Taktes ermöglicht;
- eine Taktregenerationseinheit (73), die den Takt vom Schalttor (71) empfängt, diesen regeneriert und an die anderen Schaltungseinheiten der Hochfrequenzbaugruppe sowie an einen Taktausgang, (74) weiterleitet.

**10.** Meßanordnung nach Anspruch 8 oder 9, **dadurch gekennzeichnet, daß** ein Signalumschalter (7) vorgesehen ist, der die Maximalfolge ***m*(*t*)** an einen nicht-negierenden oder an einen negierenden Eingang des Ausgangsverstärkers (8) liefert oder die Kopplung zwischen Maximalfolgengenerator (4) und Ausgangsverstärker (8) trennt.

**11.** Meßanordnung nach einem der Ansprüche 8 bis 10, **dadurch gekennzeichnet, daß** der Maximalfolgengenerator (4) einen Freigabeeingang (75) besitzt, der ein Start/Stop-Signal zum Starten der Maximalfolge empfängt, wobei das Start/Stop-Signal über eine Synchronisationsschaltung (76) zugeführt wird, welche den Zuführzeitpunkt zum Freigabeeingang (75) mit Hilfe des Abtasttaktes steuert.

**12.** Meßanordnung nach einem der Ansprüche 8 bis 11, **dadurch gekennzeichnet, daß** mehrere Hochfrequenzbaugruppen (1) parallel betrieben werden und Maximalfolgen ***m*(*t*)** an verschiedene Eingänge ($x_1$, $x_2$, $x_3$) des linearen Systems (11) liefern und Meßsignale von verschiedenen Ausgängen ($y_1$, $y_2$, $y_3$) des Systems empfangen.

**13.** Meßanordnung nach Anspruch 12, soweit dieser auf Anspruch 9 rückbezogen ist, **dadurch gekennzeichnet, daß** der Taktausgang (74) der ersten Hochfrequenzbaugruppe das Taktsignal an den Takteingang (70) der nachfolgenden Hochfrequenzbaugruppe abgibt, diese wiederum über ihren Taktausgang (74) das Taktsignal an die nachfolgende Hochfrequenzbaugruppe abgibt usw., wobei das durchgeschleifte Taktsignal die einzige hochfrequente Synchronisation zwischen den Hochfrequenzbaugruppen darstellt.

**14.** Meßanordnung nach einem der Ansprüche 8 bis 13, **dadurch gekennzeichnet, daß** ein Digital-Analog-Wandler (25) vorgesehen ist, der die in einem vorangegangenen Abtastzyklus ermittelten Abtastwerte in ein analoges Rückführsignal umwandelt, welches der Abtastschaltung (17) an einem Rückführeingang zugeführt wird, so daß nur die Differenz zwischen Rückführsignal und Meßsignal von der Abtastschaltung (17) ermittelt werden muß.

## Claims

**1.** A method for determining the pulse response g(t) of a broadband linear system which comprises the following steps:

- generating a high-frequency clock signal with a frequency $f_C \geq 100$ MHz;
- generating a periodic maximum sequence *m(t)* with an order *m* and a period of $2^m$-1 pulses of the high-frequency clock signal;
- amplifying and feeding the periodic maximum sequence *m(t)* to the broadband linear system in the form of a test signal *x(t)*;
- receiving and amplifying the response signal of the system in the form of a measuring signal *y (t)* in order to adapt its amplitude to the downstream circuit units;
- making available a sampling clock signal that is formed of the high-frequency clock signal with a division ratio $2^n$;
- sampling the analog measuring signal over at least $2^n$ periods and making available analog sampling values, wherein the sampling times are defined by the sampling clock signal and $\frac{2^m - 1}{2^n}$ sampling values are obtained per period of the measuring signal;
- converting the analog sampling values into digital sampling values that are combined into a digital measuring signal;
- determining the pulse response *g(t)* by calculating the crosscorrelation Ψ between the test signal and the digital measuring signal with the aid of a fast Hadamard transformation (FHT), in which the arrangement of the digital sampling values is taken into account.

**2.** The method according to claim 1, **characterized in that** the frequency $f_C$ of the high-frequency clock signal is adjustable.

**3.** The method according to claim 1 or 2, **characterized in that** sampling values are intermediately stored and used as reference values in the sampling of subsequent values of the measuring signal, wherein the sampling times are distributed over different periods and, if projected on one period, spaced apart from one another by no more than one period tc of the high-frequency clock signal.

**4.** The method according to one of claims 1-3, **characterized in that** the maximum sequence *m(t)* is impressed on a high-frequency carrier signal *c(t)* in order to shift the spectrum of the maximum sequence and to make available a modified maximum sequence n(t).

**5.** The method according to claim 4, **characterized in that**

- the sampling clock signal is formed with a division ratio $2^n \div$ i, wherein *i* is an odd number greater than 1 ($i = 2^n + 1$; $i > 1$) ;
- the values of the clock signal at the sampling times are arranged in a matrix *c(t)*;
- the digital sampling values are multiplied with the high-frequency clock signal and arranged in a matrix $m(t) \cdot c(t)$;
- the two initial matrices $m(t) \cdot c(t)$ and *c(t)* are subjected to a resorting, wherein the following applies to each matrix
  - the lines are combined into line groups with i lines each,
  - an intermediate matrix is formed, in which the lines are arranged in ascending order primarily in accordance with their position in the line groups and secondarily in accordance with the position of the line group in the initial matrix,

- the columns of the intermediate matrix are combined into column groups with i columns each,
- a target matrix is formed of the intermediate matrix, wherein the columns are arranged in the target matrix in ascending order primarily in accordance with their position in the column groups and secondarily in accordance with the position of the column group in the intermediate matrix; and

♦ the correlation is achieved by solving the matrix equation with the target matrices by utilizing the Hadamard transformation and simple additions.

**6.** The method according to one of claims 1-5 for determining the pulse responses of a broadband linear system with *K* inputs ($K > 1$) and/or *L* outputs ($L > 1$), **characterized in that**

♦ a maximum sequence is simultaneously or successively applied to each input of the system in the form of a test signal *x(t)*;
♦ a measuring signal *y (t)* is tapped at each output of the system;
♦ at least *K* measurements are carried out with respectively different combinations of the test signals *x(t)* at the inputs;
♦ all pulse responses *g(t)* of the system are determined.

**7.** The method according to claim 6, **characterized in that** positively or negatively polarized maximum sequences are applied or not applied to the inputs, namely in accordance with a combination pattern *A* that represents an orthogonal matrix, in particular, a Hadamard matrix.

**8.** A measuring arrangement for determining the pulse response g(t) of a broadband linear system (11), comprising

♦ a clock signal generator (2) that makes available a high-frequency clock signal $f_C$;
♦ a high-frequency module (1) (HF-part) consisting of

  * a maximum sequence generator (4) that is controlled by the high-frequency clock signal $f_C$ and delivers a maximum sequence *m(t)* of the order *m*,
  * an output amplifier (8) that receives and delivers the maximum sequence to the broadband linear system (11) in the form of a test signal,
  * a controllable input amplifier (13) that receives and amplifies a response signal from the broadband linear system (11) in the form of a measuring signal *y(t)* in order to adapt the response signal to the downstream circuit units,
  * a digital clock signal divider (18) that divides the high-frequency clock signal $f_C$ in a predetermined ratio $2^n$ and makes available a sampling clock signal, and
  * a sampling circuit (17) that is controlled by the sampling clock signal and samples the measuring signal *y(t)* received by the input amplifier (13);

♦ an analog/digital converter (19) that receives analog sampling values from the sampling circuit (17) and converts the analog sampling values into digital sampling values;
♦ an arithmetic unit (20, 21, 22) that combines the individual digital sampling values into a digital measuring signal and calculates the pulse response from this digital measuring signal and the test signal with the aid of a fast Hadamard transformation, and
♦ an interface unit (23) that delivers the pulse response to downstream display and/or storage and/or data processing units.

**9.** The measuring arrangement according to claim 8, **characterized in that** the high-frequency module is realized in the form of an integrated circuit comprising

♦ a clock signal input (70) that receives the high-frequency clock signal $f_C$;
♦ a switching gate (71) with a clock signal connection input (72) which makes it possible to switch through the high-frequency clock signal;
♦ a clock signal regeneration unit (73) that receives the clock signal from the switching gate (71), as well as regenerates and forwards the clock signal to the other circuit units of the high-frequency module and to a clock signal output (74).

**10.** The measuring arrangement according to claim 8 or 9, **characterized in that** a signal change-over switch (7) is

provided which delivers the maximum sequence m(t) to a non-negating or a negating input of the output amplifier (8) or separates the coupling between the maximum sequence generator (4) and the output amplifier (8).

**11.** The measuring arrangement according to one of claims 8-10, **characterized in that** the maximum sequence generator (4) contains an enabling input (75) that receives a start/stop signal for starting the maximum sequence, wherein the start/stop signal is received via a synchronization circuit (76) that controls the time at which the signal is fed to the enabling input (75) with the aid of the sampling clock signal.

**12.** The measuring arrangement according to one of claims 8-11, **characterized in that** several high-frequency modules (1) are operated in a parallel fashion, wherein said high-frequency modules deliver maximum sequences *m (t)* to different inputs ($x_1$, $x_2$, $x_3$) of the linear system (11) and receive measuring signals from different outputs ($y_1$, $y_2$, $y_3$) of the system.

**13.** The measuring arrangement according to claim 12, namely with respect to its reference to claim 9, **characterized in that** the clock signal output (74) of the first high-frequency module delivers the clock signal to the clock signal input (70) of the ensuing high-frequency module, and **in that** this high-frequency module delivers the clock signal to the ensuing high-frequency module via its clock signal output (74), etc., wherein the through-connected clock signal represents the only high-frequency synchronization between the high-frequency modules.

**14.** The measuring arrangement according to one of laims 8-13, **characterized in that** a digital/analog converter (25) is provided which converts the sampling values determined in a prior sampling cycle into an analog feedback signal that is delivered to a feedback input of the sampling circuit (17) such that the sampling circuit (17) only needs to determine the difference between the feedback signal and the measuring signal.

## Revendications

**1.** Procédé pour déterminer la réponse d'impulsion g(t) d'un système linéaire à larges bandes qui comprend les étapes suivantes :

- production d'un balayage à hautes fréquences avec une fréquence de $f_c \geq 100$ MHz;
- production d'une suite maximale périodique m(t) avec un ordre m et une longueur de périodes de $2^m$-1 impulsions du balayage à hautes fréquences;
- renforcement et introduction de la suite maximale périodique m(t) en tant que signal de test x(t) au système linéaire à larges bandes;
- réception et renforcement du signal de réponse du système en tant que signal de mesure y(t) pour l'adapter dans son amplitude aux unités de commutation qui suivent ;
- mise à disposition d'une cadence de balayage qui est formée à partir d'une cadence à haute fréquence dans un rapport de division $2^n$ ;
- Balayage du signal de mesure analogique sur au moins $2^n$ périodes et mise à disposition de valeurs de balayage analogiques ; les moments de balayage étant prédéterminés par la cadence de balayage et des valeurs de balayage étant récupérées à chaque période du signal de mesure $\frac{2^m - 1}{2^n}$
- Transformation des valeurs de balayage analogiques en des valeurs de balayage numériques qui seront assemblées en un signal de mesure numérique;
- Détermination de la réponse d'impulsion g(t) par le calcul de la corrélation en croix $\Psi$ entre le signal de test et le signal de mesure numérique en réalisant une transformation d'Hadamard rapide (FHT) par la prise en compte de la disposition des valeurs de balayage numériques.

**2.** Procédé selon la revendication 1, **caractérisé en ce que** la fréquence $f_c$ du balayage à hautes fréquences peut être réglée.

**3.** Procédé selon la revendication 1 ou 2, **caractérisé en ce que** les valeurs de balayage sont entrestockées et utilisés lors du balayage des valeurs suivantes du signal de mesure en tant que valeur de référence ; les moments de balayage étant répartis sur plusieurs périodes mais étant considérés comme projetés , lesdits moments de balayage n'étant pas espacés l'un de l'autre de plus d'une longueur de période $t_c$ du balayage à hautes fréquences.

**4.** Procédé selon une des revendications 1 à 3, **caractérisé en ce que** la suite maximale m(t) est imposée à un signal porteur c(t) à hautes fréquences pour pousser le spectre de la suite maximale et pour mettre à disposition

une suite maximale n(t) modifiée.

5. Procédé selon la revendication 4, **caractérisé en ce que**

- la cadence de balayage avec le rapport de séparation $2^n \div i$ sera formée où i est un nombre impair supérieur à 1 (i = 2n + 1; i > 1);
- les valeurs du signal de balayage seront disposées par rapport aux moments de balayage dans une matrice c(t);
- les valeurs de balayage numériques seront multipliées avec le signal de balayage à hautes fréquences et disposées dans une matrice m(t)·c(t);
- les deux matrices de départ m(t)·c(t) et c(t) sont soumises à une triage; où dans chaque matrice

  - les lignes sont en groupes de lignes avec chaque ligne i,
  - une matrice intermédiaire est formée dans laquelle les lignes sont disposées de façon ascendante , primaire selon leur position dans les groupes de lignes et secondaire selon la position du groupe de lignes dans la matrice de départ,
  - les colonnes de la matrice intermédiaire sont regroupées en groupes de colonnes avec chaque colonne i,
  - une matrice de cible est formée à partir de la matrice intermédiaire, dans laquelle les colonnes sont disposées de façon ascendante , primaire selon sa position dans les groupes de colonnes et secondaire selon la position du groupe de colonnes dans la matrice intermédiaire;

- qu'on réalise la corrélation en résolvant l'équation de matrice avec les matrices de cible en appliquant la transformation d'Hadamard et de simples additions.

6. Procédé selon une des revendications 1 à 5 pour déterminer les réponses d'impulsions d'un système linéaire à larges bandes avec des entrées K (K > 1) et/ou des sorties L (L > 1), **caractérisé en ce que**:

- qu'une suite maximale est appliquée en tant que signal de test x(t) en même temps ou l'une après l'autre à chaque entrée du système;
- qu'un signal de mesure y(t) est pris sur chaque sortie du système;
- qu'au moins des mesures K sont réalisées avec à chaque fois d'autres combinaisons des signaux de test x (t) aux entrées;
- que des réponses d'impulsions g(t) du système sont déterminées.

7. Procédé selon la revendication 6, **caractérisé en ce que** des suites maximales polarisées sont appliquées ou non aux entrées positives ou négatives, à savoir selon un schéma de combinaison A qui présente une matrice orthogonale, notamment une matrice d'Hadamard.

8. Disposition de mesure pour déterminer la réponse d'impulsion g(t) d'un système (11) linéaire à bandes larges, comprenant:

- un générateur de cadences (2) qui met à disposition une cadence à hautes fréquences $f_c$;
- un module à hautes fréquences (1) (partie HF) constitué de:

  - un générateur de suites maximales (4) qui est commandé par la cadence à hautes fréquences $f_c$ et produit une suite maximale m(t) de l'ordre m,
  - un amplificateur de sortie (8) ,qui reçoit la suite maximale et la transmet en tant que signal de test au système (11) linéaire à larges bandes,
  - un amplificateur d'entrée (13) réglable qui reçoit et renforce un signal de réponse du système (11) linéaire à larges bandes en tant que signal de mesure y(t) pour adapter ledit signal aux unités de commutation suivantes;
  - un séparateur de cadences (18) numérique qui répartit la cadence à hautes fréquences $f_c$ dans un rapport prédéterminé $2^n$ et met à disposition une cadence de balayage, et
  - un circuit de balayage (17) commandé par la cadence de balayage et balaye le signal de mesure y(t) reçu par l'amplificateur d'entrée (13);

- un convertisseur numérique-analogique (19) qui reçoit des valeurs de cadence analogiques du circuit de balayage et transforme celles-ci en des valeurs de balayage numériques;

- une unité de calcul (20, 21, 22) qui regroupe les différentes valeurs de balayage numériques en un signal de mesure numérique et calcule la réponse d'impulsion à partir de ce signal de mesure et du signal de test en utilisant une transformation d'Hadamard rapide; et
- une unité d'interface (23) qui émet la réponse d'impulsion vers les unités d'affichage et/ou de stockage et/ou de traitement de données suivantes.

**9.** Disposition de mesure selon la revendication 8,
**caractérisée en ce que** le module à hautes fréquences est conçu en tant que circuit intégré, comprenant:

- une entrée de cadences (70) dans laquelle la cadence à haute fréquences $f_c$ est alimentée;
- un port de commutation (71) avec une entrée de connexion (72) qui permet la connexion transversale de la cadence à hautes fréquences;
- une unité de génération de cadences (73) qui reçoit la cadence du port de commutation (71), rafraîchit celle-ci et la transmet aux autres unités de commutation du module à hautes fréquences ainsi qu'à une sortie de cadences (74).

**10.** Disposition de mesure selon la revendication 8 ou 9, **caractérisée en ce qu'**un commutateur de signaux (7) est prévu qui fournit la suite maximale m(t) à une entrée non négativante ou une entrée négativante de l'amplificateur de sortie (8) ou sépare le couplage entre le générateur de suites maximal (4) et l'amplificateur de sortie (8).

**11.** Disposition de mesure selon une des revendications 8 à 10, **caractérisée en ce que** le générateur de suites maximal (4) comporte une entrée déclenchement (75) qui reçoit un signal de démarrage/d'arrêt pour démarrer la suite maximale; le signal de démarrage/d'arrêt étant amené par un circuit de synchronisation (76) qui commande le moment d'amenée vers l'entrée de déclenchement (75) avec l'aide de la cadence de balayage.

**12.** Disposition de mesure selon une des revendications 8 à 11, **caractérisée en ce que** plusieurs modules à hautes fréquences (1) sont exploités de façon parallèle et fournissent des suites maximales m(t) aux différentes entrées ($x_1$, $x_2$, $x_3$) du système linéaire (11) et reçoivent des signaux de mesure des différentes sorties ($y_1$, $y_2$, $y_3$) du système.

**13.** Disposition de mesure selon la revendication 12 dans la mesure où celle-ci se réfère à la revendication 9, **caractérisée en ce que** la sortie de cadences (74) du premier module à hautes fréquences émet le signal de cadence à l'entrée de cadences (70) du module à hautes fréquences suivant, celui-ci émettant à son tour par sa sortie de cadences (74) le signal de balayage au module à hautes fréquences suivant et ainsi dé suite; le signal de cadence en boucle représentant la seule synchronisation à hautes fréquences entre les modules à hautes fréquences.

**14.** Disposition de mesure selon une des revendications 8 à 13, **caractérisée en ce qu'**un convertisseur analogique-numérique (25) est prévu, qui convertit des valeurs de balayage transmises pendant un cycle de balayage antérieure en un signal de retour analogique, lequel signal est introduit au circuit de balayage (17) à une entrée de retour de manière à ce que seule la différence entre le signal de retour et le signal de mesure doit être déterminée par le circuit de balayage (17).

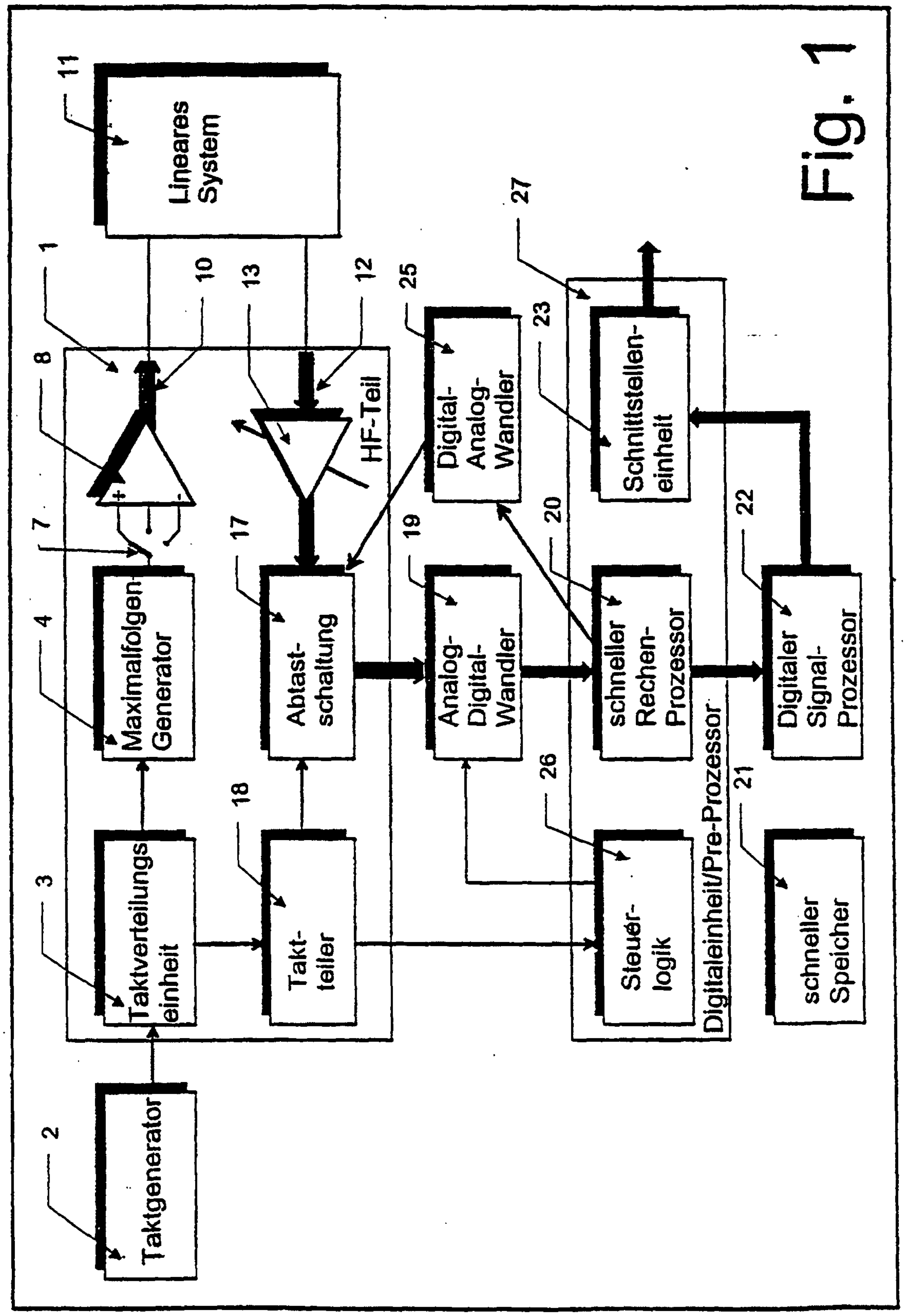
Lineares System
Taktgenerator
Taktverteilungseinheit
Maximalfolgen Generator
Takt-teiler
Abtast-schaltung
HF-Teil
Digital-Analog-Wandler
Analog-Digital-Wandler
Steuer-logik
schneller Rechen-Prozessor
Schnittstellen-einheit
Digitaler Signal-Prozessor
schneller Speicher
Digitaleinheit/Pre-Prozessor
1
2
3
4
7
8
10
11
12
13
17
18
19
20
21
22
23
25
26
27

Fig. 1

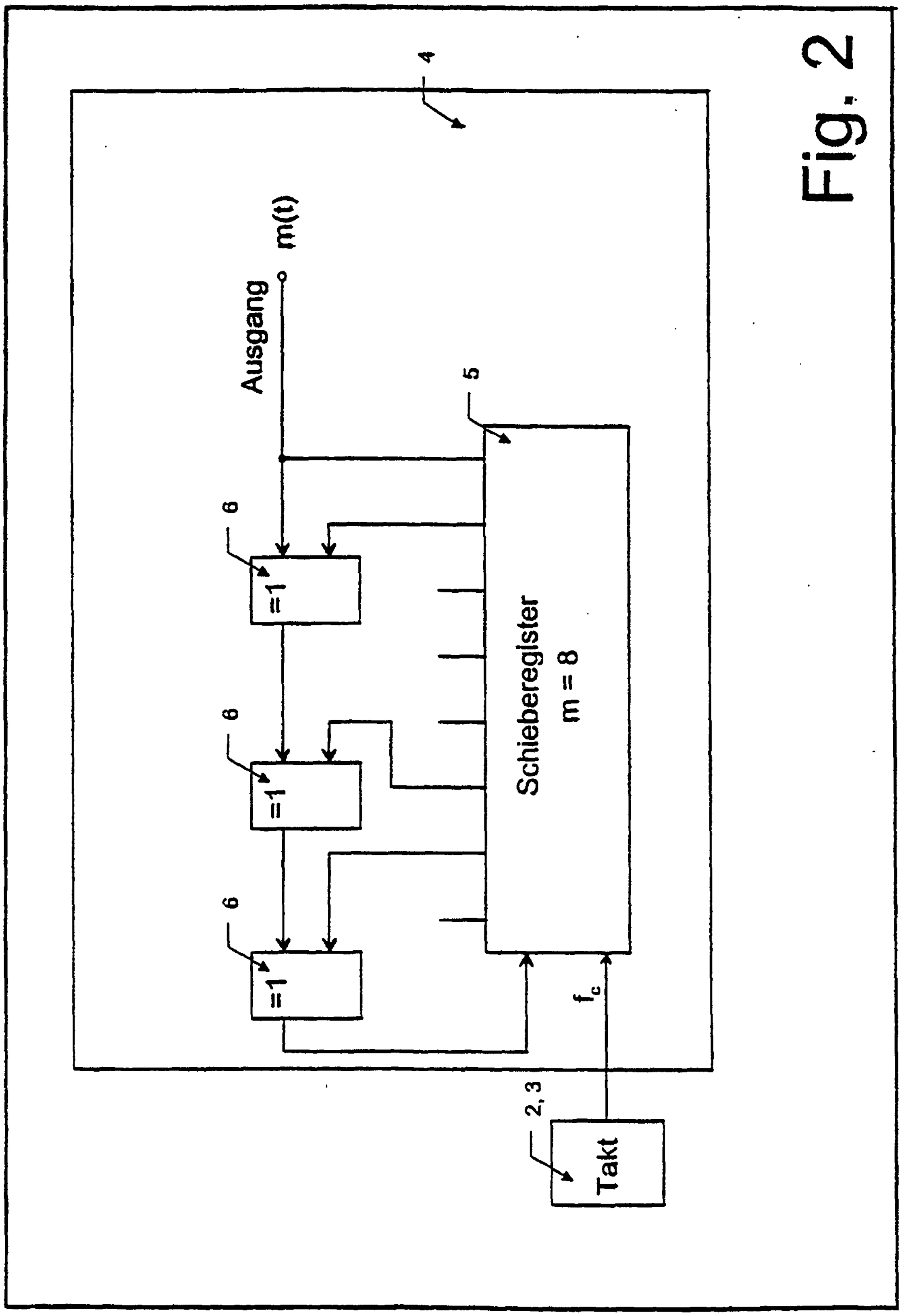


Fig. 2

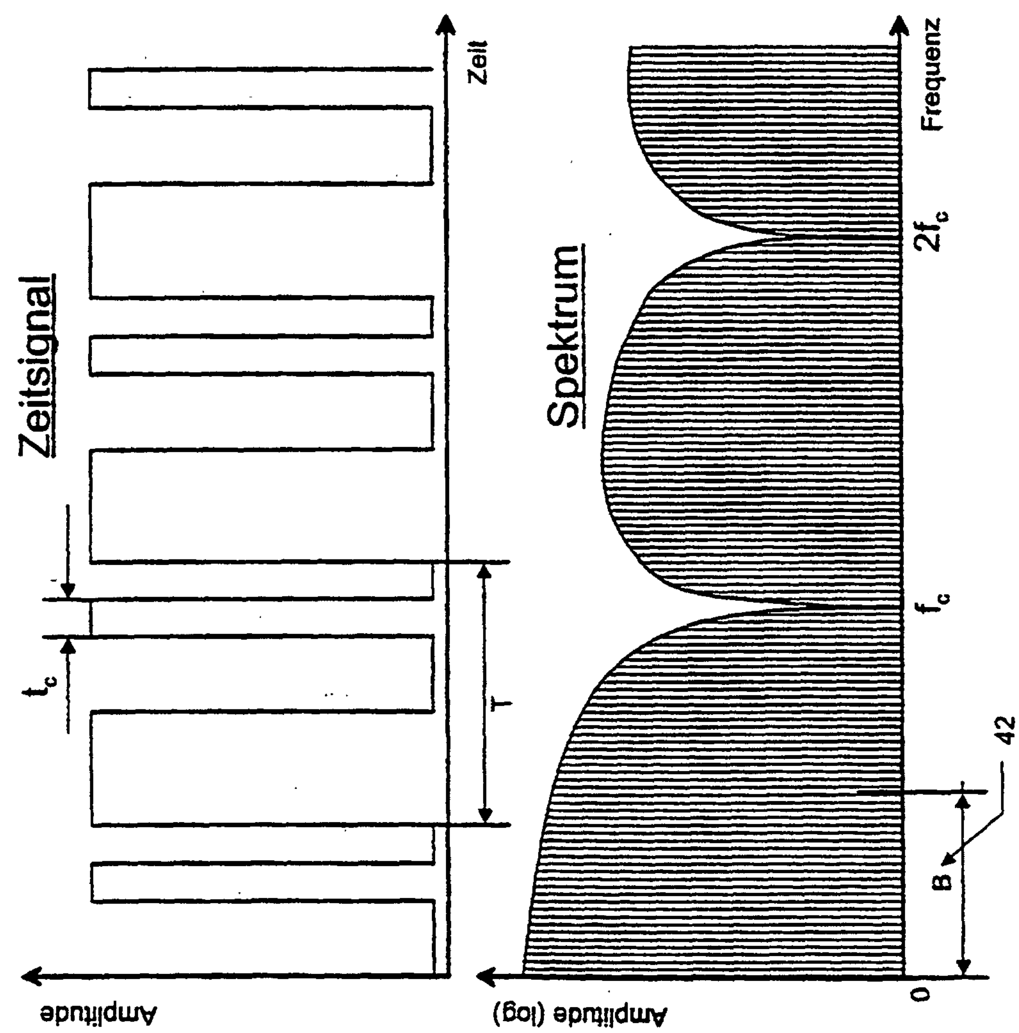

Zeitsignal
$t_c$
T
Zeit
Amplitude
Spektrum
Frequenz
Amplitude (log)
0
B
42
$f_c$
$2f_c$


Fig. 3

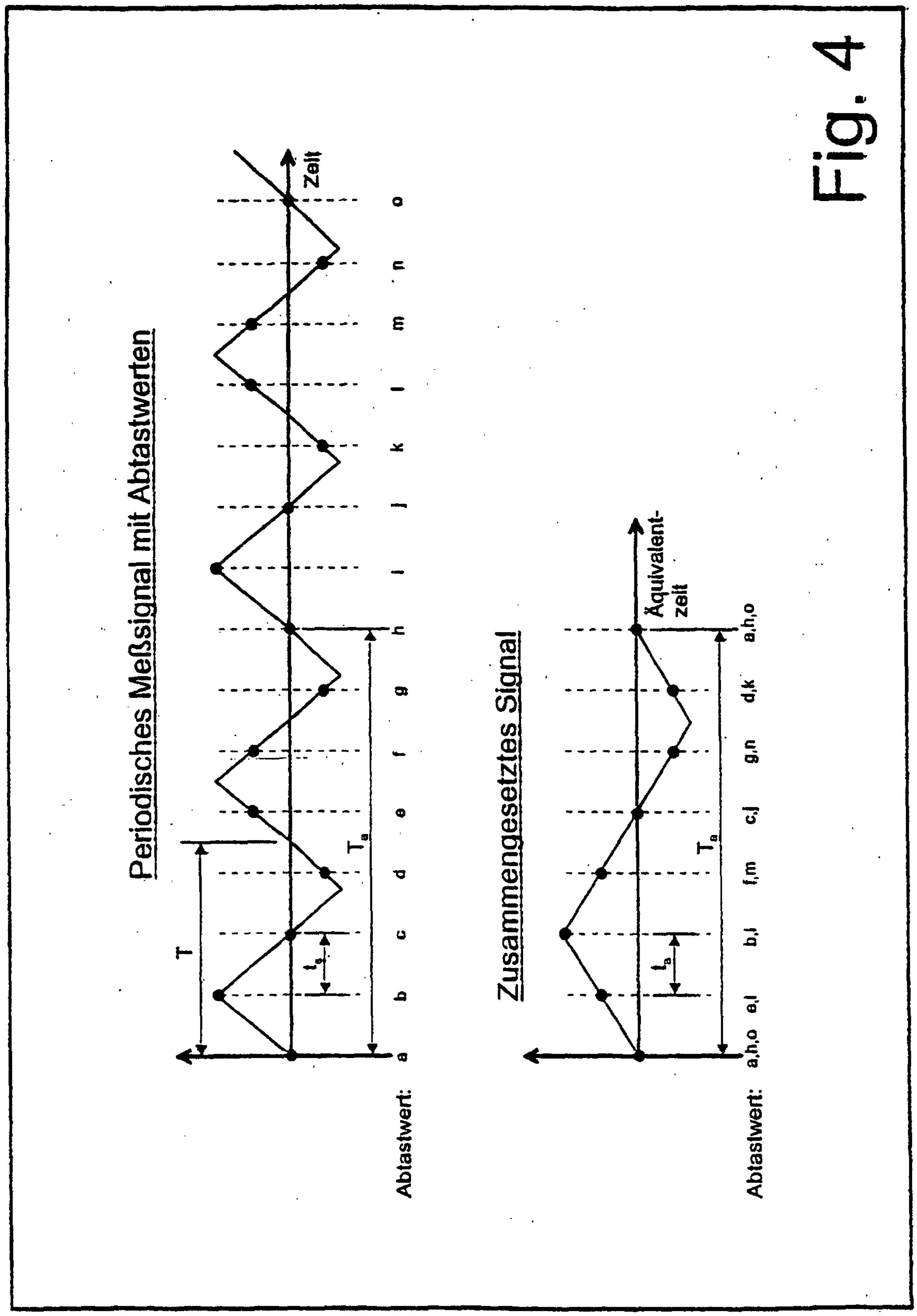
Periodisches Meßsignal mit Abtastwerten
Zeit
T
$t_s$
$T_a$
Abtastwert: a b c d e f g h i j k l m n o
Zusammengesetztes Signal
Äquivalent-
zeit
$t_a$
$T_a$
Abtastwert: a,h,o e,l b,i f,m c,j g,n d,k a,h,o

Fig. 4

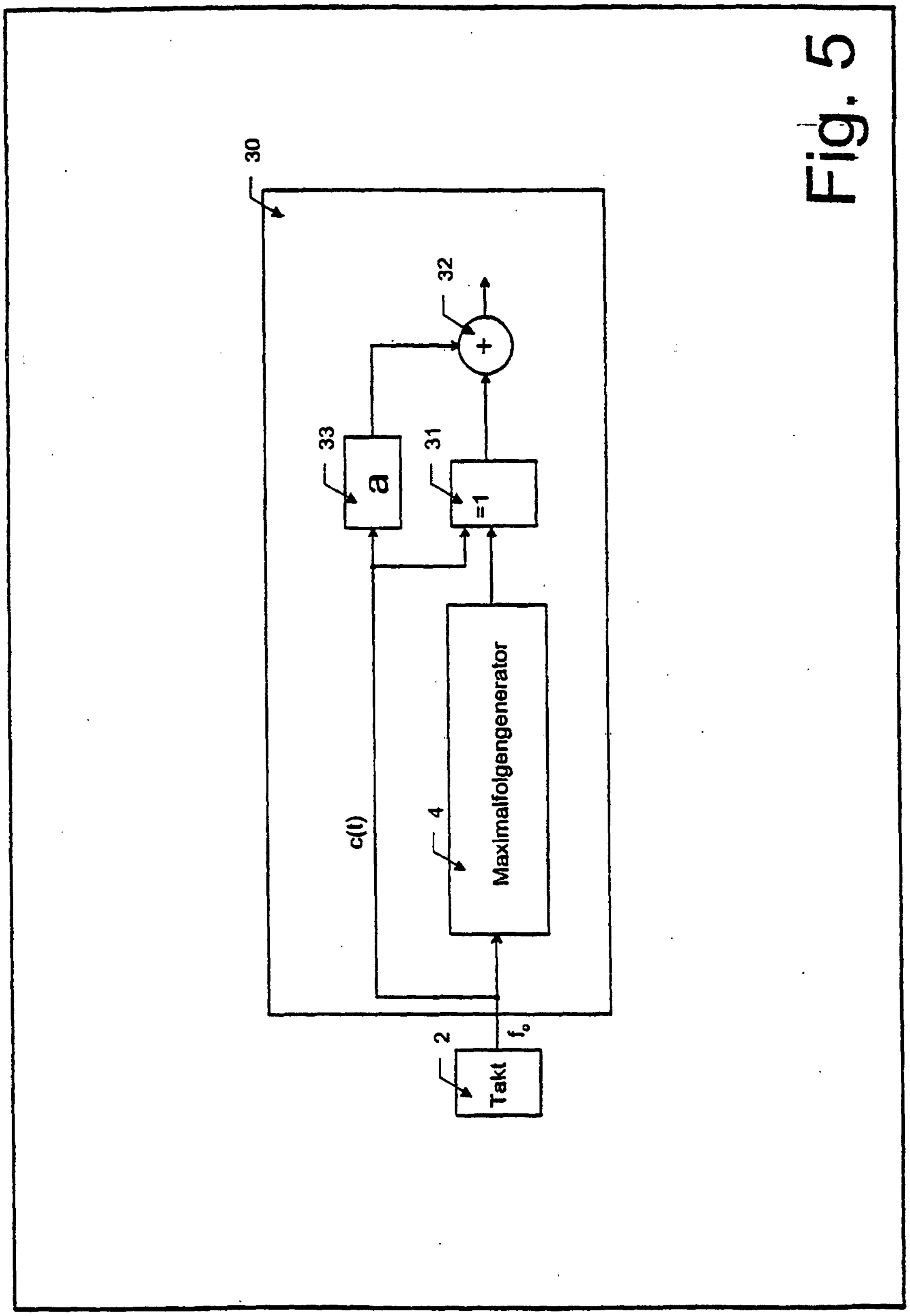


Fig. 5

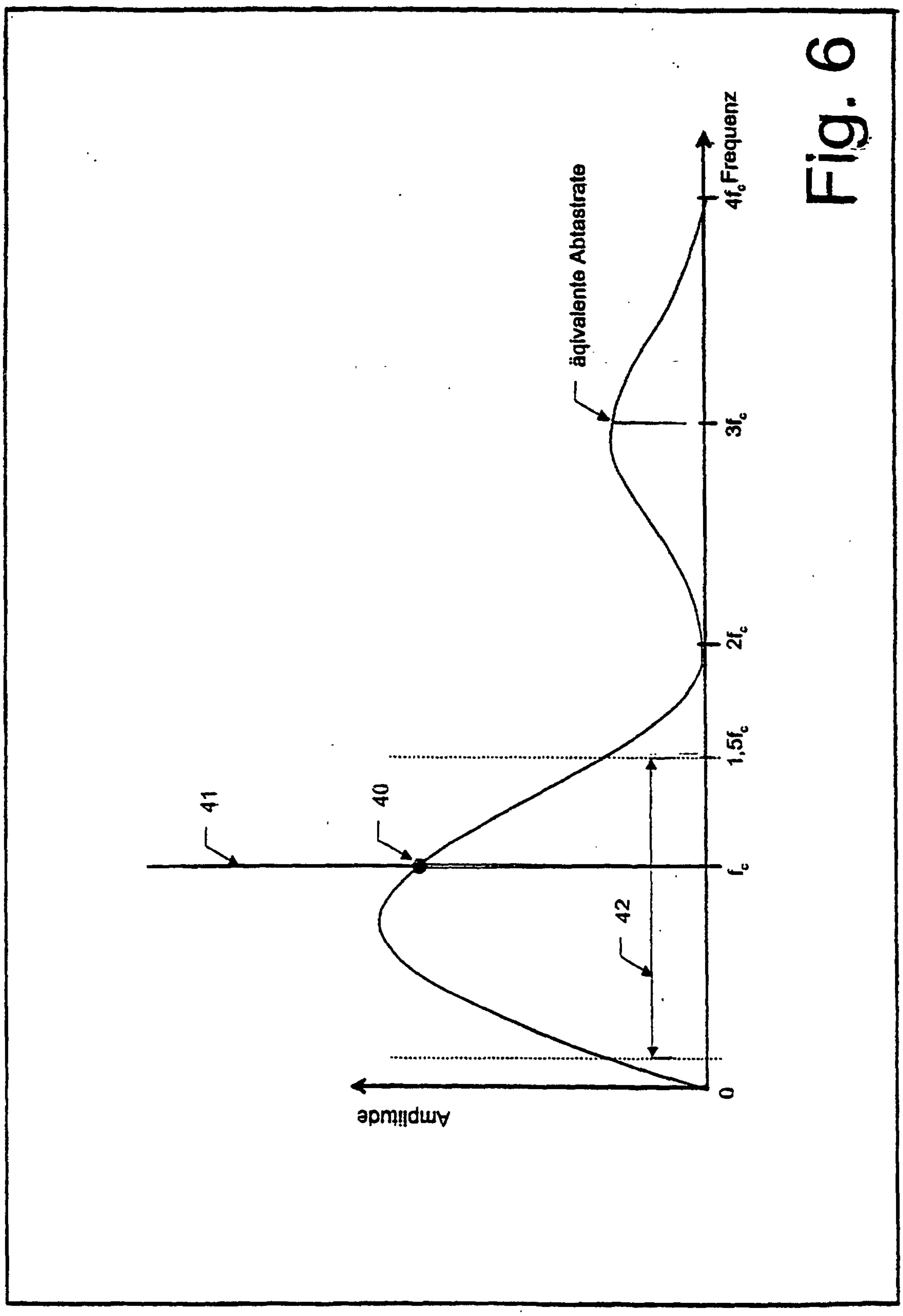
Amplitude
Frequenz
äqivalente Abtastrate
0
f_c
1,5f_c
2f_c
3f_c
4f_c
40
41
42

Fig. 6

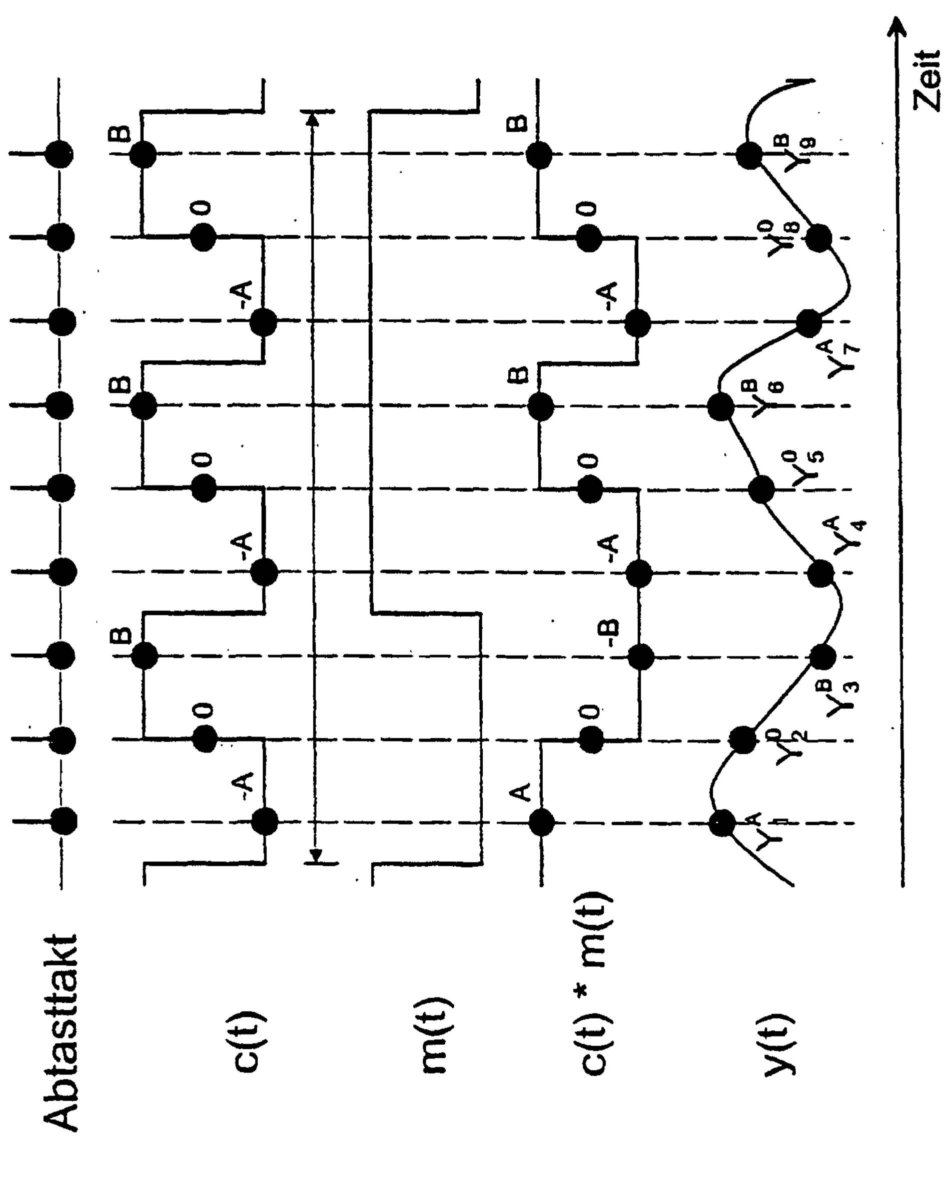
Abtasttakt
c(t)
m(t)
c(t) * m(t)
y(t)
Zeit
A
-A
0
B
-B
$Y_1^A$
$Y_2^0$
$Y_3^B$
$Y_4^A$
$Y_5^0$
$Y_6^B$
$Y_7^A$
$Y_8^0$
$Y_9^B$

Fig. 7

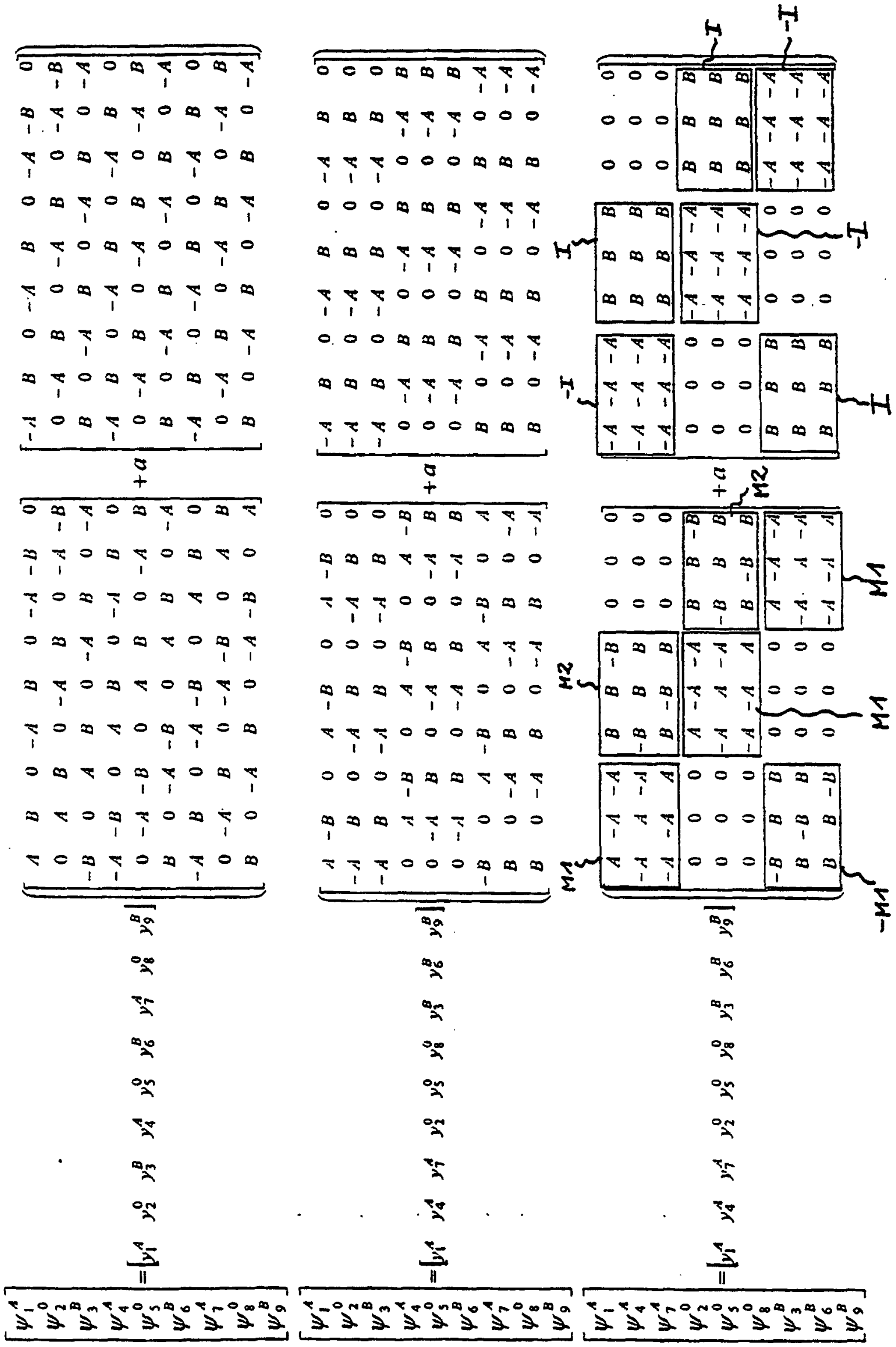


Fig. 8

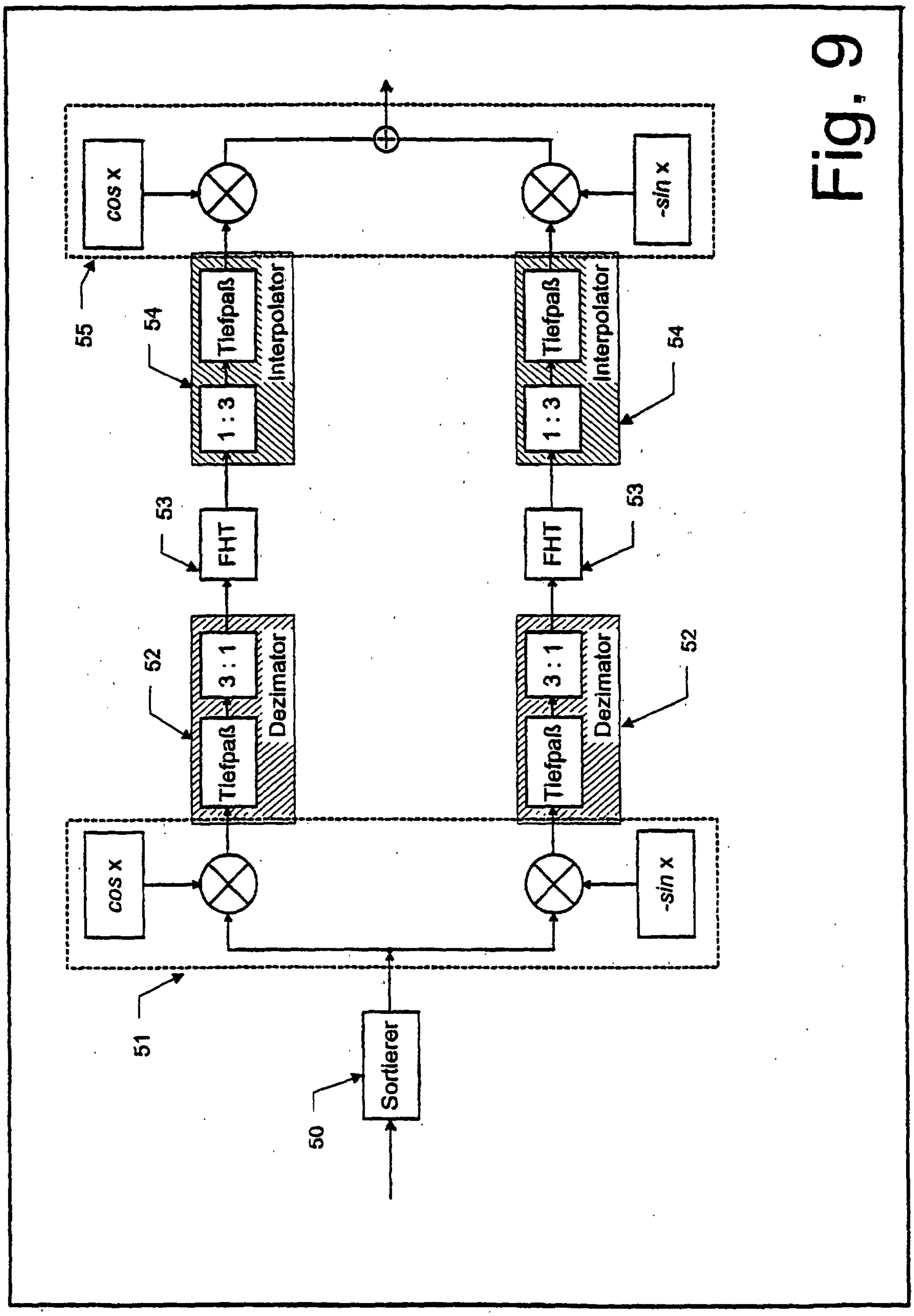
cos x
-sin x
Tiefpaß
3 : 1
Dezimator
FHT
1 : 3
Tiefpaß
Interpolator
cos x
-sin x
Sortierer
50
51
52
53
54
55

Fig. 9

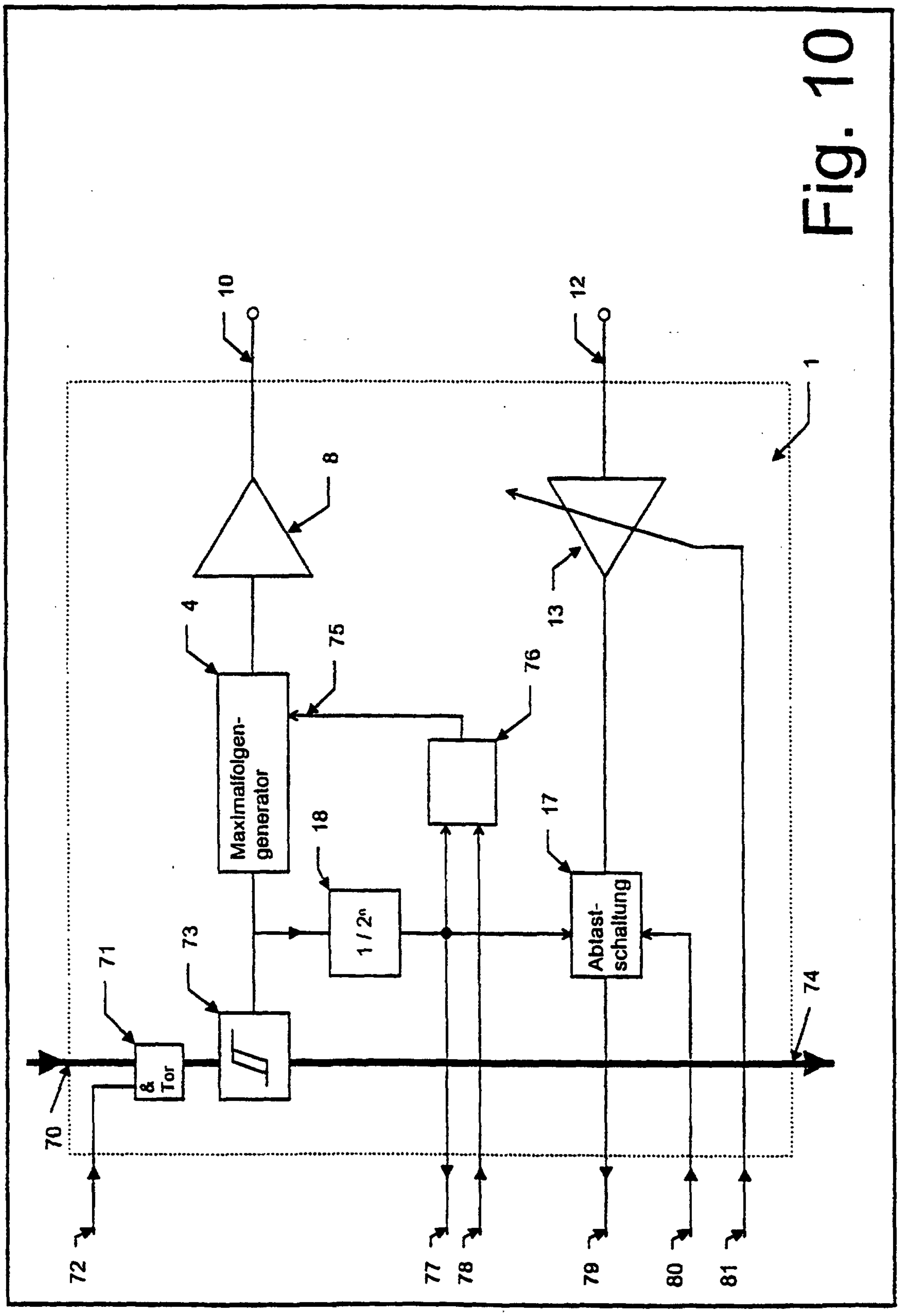
10
12
1
8
13
4
75
76
Maximalfolgen-
generator
18
17
1 / 2ⁿ
Ablast-
schaltung
73
71
& Tor
74
70
72
77
78
79
80
81

Fig. 10

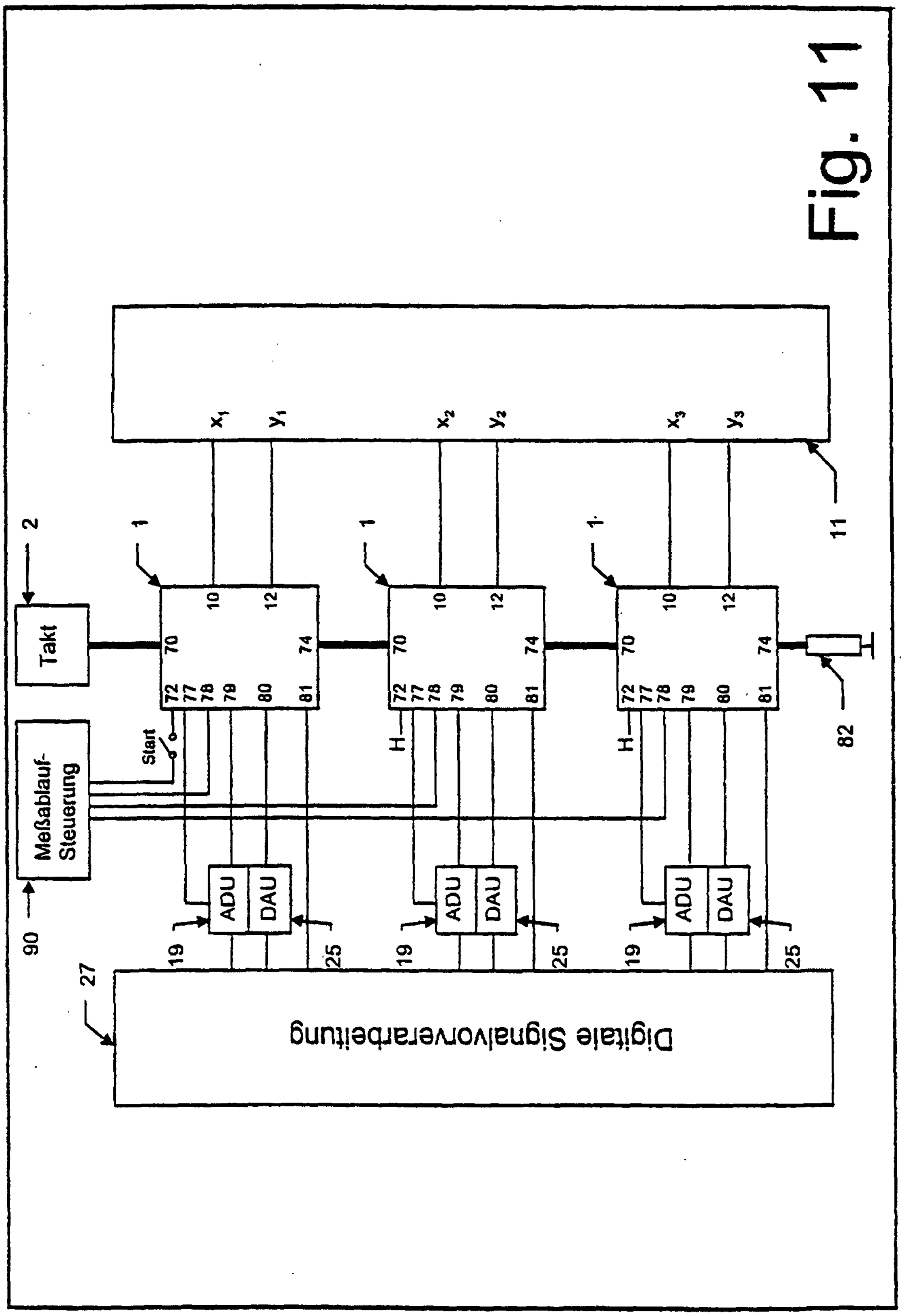
Takt
Meßablauf-Steuerung
Start
ADU
DAU
Digitale Signalvorverarbeitung
H
x1
y1
x2
y2
x3
y3
1
2
10
11
12
19
25
27
70
72
74
77
78
79
80
81
82
90

Fig. 11